# EUROPEAN PATENT APPLICATION

(11) **EP 4 672 950 A1**
(43) Date of publication of application: **31.12.2025**
(21) Application number: 24760369.9
(22) Date of filing: 20.02.2024
(51) Int. Cl.: H10N 10/13, H02N 11/00, H10N 10/01, H10N 10/17

(54) **THERMOELECTRIC CONVERSION MODULE AND MANUFACTURING METHOD FOR SAME**

(30) Priority: 21.02.2023 JP 2023025238
(71) Applicant: Denka Company Limited, Tokyo 103-8338 (JP)
(72) Inventor: NIWA, Ryota, Tokyo 103-8338 (JP); ASAMI, Takeshi, Tokyo 103-8338 (JP); MAEDA, Ryota, Tokyo 103-8338 (JP)
(74) Representative: Müller-Boré & Partner Patentanwälte PartG mbB
(86) International application number: PCT/JP2024/006070
(87) International publication number: WO 2024/177071

(57) **Abstract**

A thermoelectric conversion module provided with: a substrate having a first main surface and a second main surface; a thermoelectric conversion portion located on the first main surface; an encapsulation layer located on the thermoelectric conversion portion; a first thermally conductive portion and a second thermally conductive portion located on the second main surface; and a thermally insulating member located on the second main surface. The thermoelectric conversion portion has a p-type thermoelectric conversion element and an n-type thermoelectric conversion element, a first end of the p-type thermoelectric conversion element contacts a first end of the n-type thermoelectric conversion element, the first thermally conductive portion overlaps with a second end of the p-type thermoelectric conversion element, the second thermally conductive portion overlaps with a second end of the n-type thermoelectric conversion element, the encapsulation layer has a thickness of at least 5 µm and at most 150 µm, a water vapor transmission rate of at most 100 g/(m²·day), an emissivity of at least 0.70 and at most 0.99, and a thermal conductivity of at least 0.01 W/mK and at most 50 W/mK.

## Description

### TECHNICAL FIELD

The present disclosure relates to a thermoelectric conversion module and a manufacturing method for the same.

### BACKGROUND

Thermoelectric conversion elements are sometimes used to generate power by utilizing terrestrial heat, waste heat from factories, etc. Patent Document 1 below discloses an embodiment in which flexible substrates having pattern layers comprising a resin layer and a metal layer are provided on both surfaces of a thermoelectric conversion module having a P-type thermoelectric element material and an N-type thermoelectric element material. In Patent Document 1 below, the metal layer contained in one of the flexible substrates overlaps with one of the electrodes contained in the thermoelectric conversion module and the metal layer contained in the other of the flexible substrates overlaps with another of the electrodes contained in the thermoelectric conversion module. In the above-mentioned embodiment, one of the flexible substrates is put in a high-temperature state and the other of the flexible substrates is put in a low-temperature state, thereby creating a temperature difference in the planar direction of the thermoelectric conversion module. This creates an electromotive force in the thermoelectric conversion module.

### CITATION LIST

### PATENT LITERATURE

Patent Document 1: JP 2008-182160 A

### SUMMARY OF INVENTION

### TECHNICAL PROBLEM

In order to ensure increased output power from thermoelectric conversion modules such as those described in Patent Document 1 above, one might contemplate, for example, widening the above-mentioned temperature difference to increase the thermoelectric conversion efficiency. Methods for widening the above-mentioned temperature difference in the above-mentioned Patent Document 1 include, for example, thinning the P-type thermoelectric element material and the N-type thermoelectric element material and increasing the distance between the above-mentioned metal layers. However, in the former case, the electrical resistance of each thermoelectric element material increases as each thermoelectric element material is made thinner. Additionally, in the latter case, the number of elements per unit area becomes smaller as the above-mentioned distance is increased. For this reason, simply widening the above-mentioned temperature difference can cause the output power from the thermoelectric conversion modules per unit area to conversely decrease.

An objective of one aspect of the present disclosure is to provide a thermoelectric conversion module that has stably high output power and long-term reliability allowing the same to be sustained for a long time, and that can stably generate power even when deformed; and a manufacturing method for such a thermoelectric conversion module.

### SOLUTION TO PROBLEM

A thermoelectric conversion module and a manufacturing method for the same according to one aspect of the present disclosure are as indicated below.
[1] A thermoelectric conversion module comprising:
   a substrate having a first main surface, and a second main surface located on a side opposite to the first main surface;
   a thermoelectric conversion portion located on the first main surface;
   an encapsulation layer located on the thermoelectric conversion portion;
   a first thermally conductive portion and a second thermally conductive portion that are located on the second main surface and that are adjacent to each other in a first direction orthogonal to a thickness direction of the substrate; and
   a thermally insulating member that is located on the second main surface, at least between the first thermally conductive portion and the second thermally conductive portion;
   the thermoelectric conversion portion has a p-type thermoelectric conversion element and an n-type thermoelectric conversion element that are arranged side by side in the first direction;
   a first end of the p-type thermoelectric conversion element in the first direction contacts a first end of the n-type thermoelectric conversion element in the first direction, and overlaps with the thermally insulating member in the thickness direction;
   the first thermally conductive portion overlaps, in the thickness direction, with a second end of the p-type thermoelectric conversion element in the first direction;
   the second thermally conductive portion overlaps, in the thickness direction, with a second end of the n-type thermoelectric conversion element in the first direction;
   the encapsulation layer has, in the thickness direction, a thickness of at least 5 µm and at most 150 µm, and a water vapor transmission rate of at most 100 g/(m²·day); and
   an emissivity of the encapsulation layer is at least 0.70 and at most 0.99, and a thermal conductivity of the encapsulation layer is at least 0.01 W/mK and at most 50 W/mK.
[2] The thermoelectric conversion module according to [1], wherein the encapsulation layer has a water vapor transmission rate of at least 0.1 g/(m²·day) and at most 100 g/(m²·day).
[3] The thermoelectric conversion module according to either [1] or [2], wherein a difference in linear expansion coefficient between the first thermally conductive portion and the thermally insulating member and a difference in linear expansion coefficient between the second thermally conductive portion and the thermally insulating member are each at most 100 ppm/K.
[4] The thermoelectric conversion module according to any one of [1]-[3], wherein the p-type thermoelectric conversion element and the n-type thermoelectric conversion element each have a thickness of at least 3 µm and at most 30 µm.
[5] The thermoelectric conversion module according to any one of [1]-[4], wherein:
   the first thermally conductive portion and the second thermally conductive portion each have a linear expansion coefficient of at least 100 ppm/K and at most 200 ppm/K; and
   the linear expansion coefficient of the thermally insulating member is at most 200 ppm/K.
[6] The thermoelectric conversion module according to any one of [1]-[5], wherein the first thermally conductive portion and the second thermally conductive portion each have a width, in the first direction, of at least 0.5 mm and at most 1.5 mm.
[7] The thermoelectric conversion module according to any one of [1]-[6], wherein:
   the first thermally conductive portion and the second thermally conductive portion each have a thermal conductivity of at least 2 W/mK and at most 5 W/mK; and
   the thermal conductivity of the thermally insulating member is at least 0.02 W/mK and at most 0.05 W/mK.
[8] The thermoelectric conversion module according to any one of [1]-[7], wherein:
   a heat dissipation member located on the second main surface is further provided; and
   viewed from the thickness direction, the heat dissipation member surrounds the first thermally conductive portion, the second thermally conductive portion, and the thermally insulating member.
[9] The thermoelectric conversion module according to any one of [1]-[8], wherein:
   the p-type thermoelectric conversion element and the n-type thermoelectric conversion element each have a thickness of at least 5 µm and at most 25 µm; and
   a spacing between the first thermally conductive portion and the second thermally conductive portion in the first direction is at least 3 mm and less than 12 mm.
[10] The thermoelectric conversion module according to any one of [1]-[9], further comprising:
   a first thermoelectric conversion group that is located on the first main surface and that has the thermoelectric conversion portion; and
   a second thermoelectric conversion group that is located on the first main surface and that is adjacent to the first thermoelectric conversion group in a second direction that is orthogonal to the thickness direction and to the first direction;
   wherein
   the second thermoelectric conversion group has a second thermoelectric conversion portion adjacent to the first thermoelectric conversion portion in the second direction;
   the second thermoelectric conversion portion has a second p-type thermoelectric conversion element and a second n-type thermoelectric conversion element that are arranged side by side in the first direction;
   a first end of the second p-type thermoelectric conversion element in the first direction contacts a first end of the second n-type thermoelectric conversion element in the first direction, and overlaps with the thermally insulating member in the thickness direction;
   the first thermally conductive portion and the second thermally conductive portion each extend in the second direction;
   the first thermally conductive portion overlaps, in the thickness direction, with a second end, in the first direction, of the second p-type thermoelectric conversion element included in the second thermoelectric conversion portion; and
   the second thermally conductive portion overlaps, in the thickness direction, with a second end, in the first direction, of the second n-type thermoelectric conversion element included in the second thermoelectric conversion portion.
[11] The thermoelectric conversion module according to [10], further comprising:
   a first electrically conductive portion that is located on the first main surface and that is connected to one end of the first thermoelectric conversion group in the first direction; and
   a second electrically conductive portion that is located on the first main surface and that is connected to the other end of the first thermoelectric conversion group in the first direction and to one end of the second thermoelectric conversion group in the second direction;
   wherein the first electrically conductive portion and the second electrically conductive portion are each of the same conductivity type.
[12] The thermoelectric conversion module according to any one of [1]-[11], wherein the substrate, the thermoelectric conversion portion, the first thermally conductive portion, the second thermally conductive portion, and the thermally insulating member each exhibit flexibility.
[13] A manufacturing method for a thermoelectric conversion module, the manufacturing method comprising:
   a first step of forming a first thermally conductive portion, a second thermally conductive portion, and a thermally insulating member on one main surface of a substrate;
   a second step of forming a first layer including a p-type thermoelectric conversion material on the other main surface of the substrate;
   after the second step, a third step of immersing the other main surface of the substrate in an organic solvent, thereby forming a p-type thermoelectric conversion layer;
   after the third step, a fourth step of dripping a dopant solution onto a portion of the p-type thermoelectric conversion layer, thereby forming a p-type thermoelectric conversion element, and an n-type thermoelectric conversion element at said portion; and
   after the fourth step, a fifth step of disposing an encapsulation layer on the other main surface of the substrate so as to cover the p-type thermoelectric conversion element and the n-type thermoelectric conversion element;
   wherein
   the first thermally conductive portion and the second thermally conductive portion are adjacent to each other in a first direction orthogonal to a thickness direction of the substrate;
   a first end of the p-type thermoelectric conversion element in the first direction contacts a first end of the n-type thermoelectric conversion element in the first direction, and overlaps with the thermally insulating member in the thickness direction;
   the first thermally conductive portion overlaps, in the thickness direction, with a second end of the p-type thermoelectric conversion element in the first direction;
   the second thermally conductive portion overlaps, in the thickness direction, with a second end of the n-type thermoelectric conversion element in the first direction;
   the encapsulation layer has, in the thickness direction, a thickness of at least 10 µm and at most 150 µm, and a water vapor transmission rate of at most 100 g/(m²·day); and
   an emissivity of the encapsulation layer is at least 0.70 and at most 0.99, and a thermal conductivity of the encapsulation layer is at least 0.01 W/mK and at most 50 W/mK.
[14] The manufacturing method according to [13], wherein the encapsulation layer has a water vapor transmission rate of at least 0.1 g/(m²·day) and at most 100 g/(m²·day).

### EFFECTS OF INVENTION

According to one aspect of the present disclosure, it is possible to provide a thermoelectric conversion module that has stably high output power and long-term reliability allowing the same to be sustained for a long time, and that can stably generate power even when deformed; and a manufacturing method for such a thermoelectric conversion module.

### BRIEF DESCRIPTION OF DRAWINGS

FIG. 1(a) is a schematic plan view illustrating a thermoelectric conversion module according to an embodiment; FIG. 1(b) is a schematic bottom view illustrating a thermoelectric conversion module according to an embodiment.
FIG. 2(a) is a schematic plan view for explaining a thermoelectric conversion module according to an embodiment; FIG. 2(b) is a schematic bottom view for explaining a thermoelectric conversion module according to an embodiment.
FIG. 3(a) is an enlarged view of a portion of FIG. 2(a) (the area surrounded by the single-dotted chain lines); FIG. 3(b) is a section view along the line IIIb-IIIb in FIG. 3(a).
FIG. 4(a) is a schematic section view illustrating, in an enlarged manner, a portion of a thermoelectric conversion module according to an embodiment; FIG. 4(b) is a schematic section view illustrating, in an enlarged manner, a portion of a thermoelectric conversion module according to a modified example.
FIG. 5(a) and (b) are diagrams for explaining a manufacturing method for a thermoelectric conversion module according to an embodiment.
FIG. 6(a) and (b) are diagrams for explaining a manufacturing method for a thermoelectric conversion module according to an embodiment.
FIG. 7(a) and (b) are diagrams for explaining a manufacturing method for a thermoelectric conversion module according to an embodiment.
FIG. 8 is a schematic section view illustrating a portion of a thermoelectric conversion module when deformed.
FIG. 9(a) is a schematic bottom view of a thermoelectric conversion module according to a modified example; FIG. 9(b) is a schematic section view along the line IXb-IXb in FIG. 9(a).
FIG. 10 is a schematic plan view for explaining a thermoelectric conversion module according to a modified example.

### DESCRIPTION OF EMBODIMENTS

Hereinafter, embodiments of the present disclosure will be explained in detail by referring to the attached drawings. In the explanation below, identical elements or elements having identical functions will be assigned identical reference signs and redundant explanations will be omitted. The term "identical" and terms similar thereto in the present description are not limited to meaning only "completely identical".

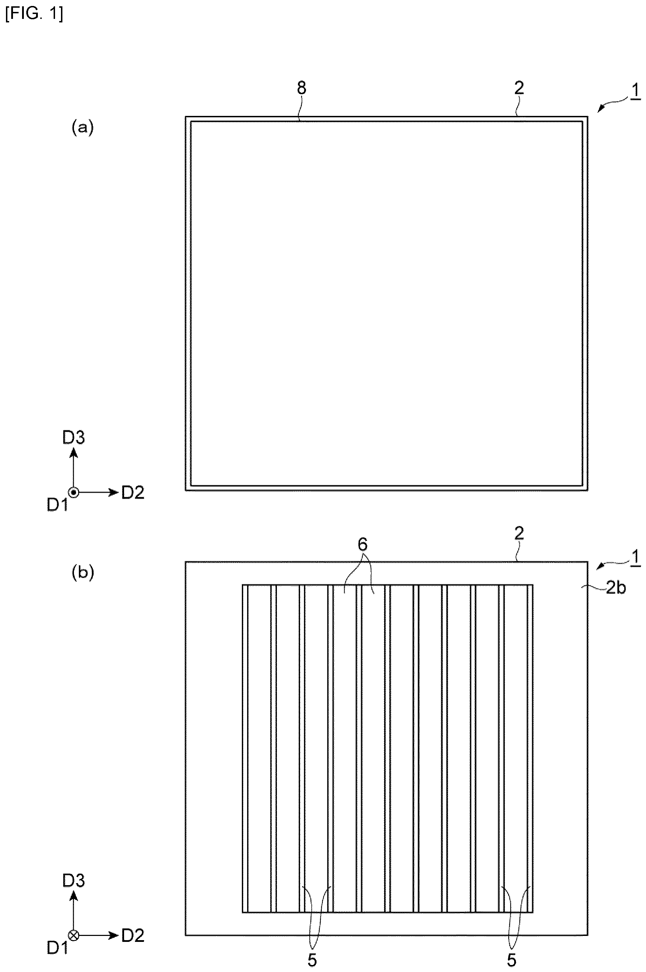

First, the configuration of the thermoelectric conversion module according to the present embodiment will be explained with reference to FIG. 1, FIG. 2, FIG. 3, and FIG. 4.

FIG. 1(a) is a schematic plan view illustrating a thermoelectric conversion module according to the embodiment. FIG. 1(b) is a schematic bottom view illustrating the thermoelectric conversion module according to the embodiment.

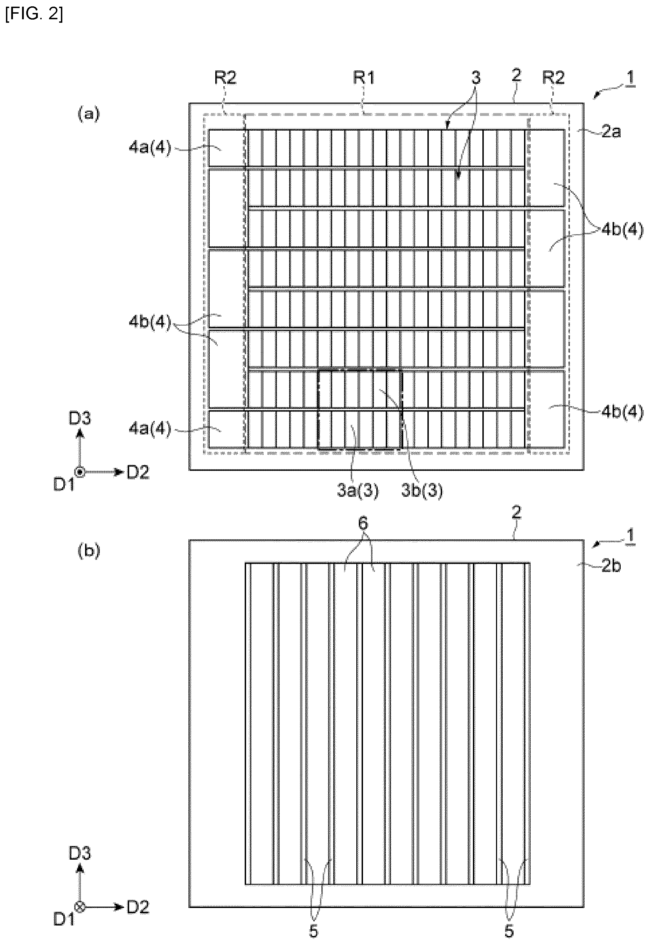

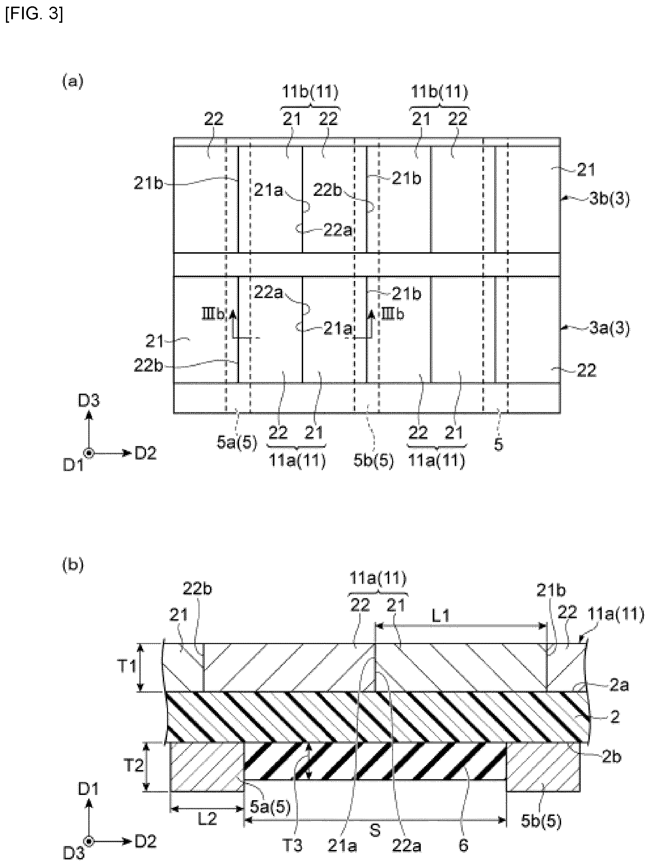

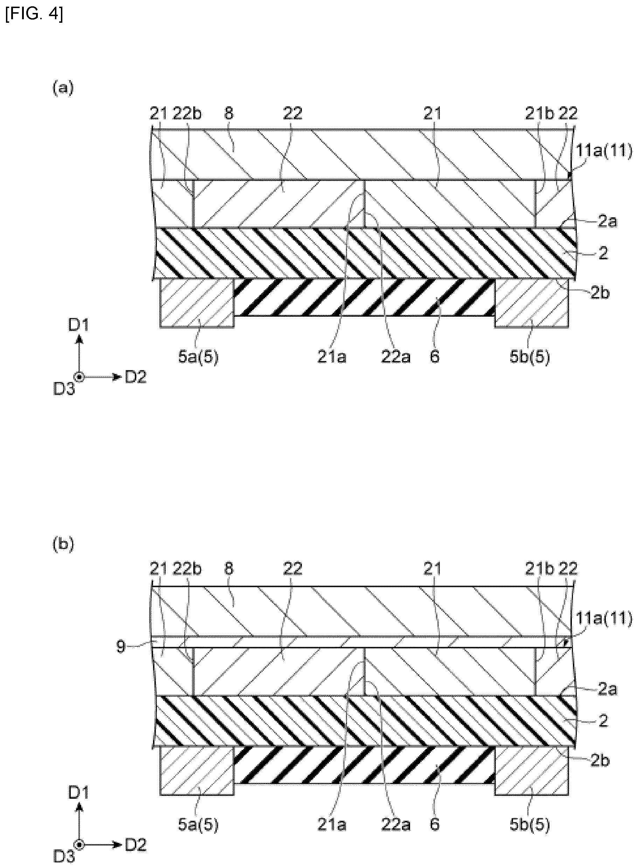

FIG. 2(a) is a schematic plan view for explaining the thermoelectric conversion module according to the embodiment. FIG. 2(b) is a schematic bottom view for explaining a thermoelectric conversion module according to the embodiment. FIG. 2(a) and (b) are diagrams illustrating the thermoelectric conversion module 1 illustrated in FIG. 1(a) and (b) in a state in which an encapsulation layer 8 has been removed, and can be considered to be diagrams illustrating the state before providing the encapsulation layer 8 when manufacturing the thermoelectric conversion module 1 illustrated in FIG. 1(a) and (b). FIG. 3(a) is an enlarged view of a portion of FIG. 2(a) (the area surrounded by the single-dotted chain lines). FIG. 3(b) is a section view along the line Illb-Illb in FIG. 3(a). FIG. 4(a) is a schematic section view illustrating, in an enlarged manner, a portion (a portion corresponding to FIG. 3(a)) of the thermoelectric conversion module according to the embodiment. FIG. 4(b) is a schematic section view illustrating, in an enlarged manner, a portion (the portion corresponding to FIG. 3(a)) of a thermoelectric conversion module according to a modified example.

The thermoelectric conversion module 1 illustrated in FIG. 1 and FIG. 2 is a device that can generate power by being supplied with heat from the outside. The thermoelectric conversion module 1 is a so-called in-plane type device. For this reason, the thermoelectric conversion module 1 tends to have superior workability and flexibility than, for example, π-type elements (cross-plane type elements) do. Thus, the thermoelectric conversion module 1 can be provided, for example, along side surfaces of tubular pipes, etc. used for recovering factory waste heat. That is, the thermoelectric conversion module 1 can be easily disposed in various locations. Thus, the thermoelectric conversion module 1 is used, for example, as a power source for a plant sensor utilizing waste heat. Additionally, the contact resistance between the thermoelectric conversion material and electrodes included in the thermoelectric conversion module 1 also tends to be lower than that in π-type modules. Hereinafter, the temperatures of the constituent elements in the thermoelectric conversion module 1 will be assumed to have been measured under natural air convection conditions.

The thermoelectric conversion module 1 has a substrate 2, a plurality of thermoelectric conversion groups 3, a plurality of electrically conductive portions 4, a plurality of thermally conductive portions 5, a plurality of thermally insulating members 6, and an encapsulation layer 8. At least one of the substrate 2, the plurality of thermoelectric conversion groups 3, the plurality of electrically conductive portions 4, the plurality of thermally conductive portions 5, the plurality of thermally insulating members 6, and the encapsulation layer 8 exhibits flexibility.

The substrate 2 is a resin sheet member that exhibits heat resistance and flexibility, and for example, is substantially sheet-shaped. The resin constituting the substrate 2 is, for example, a polyalkylene-based resin (for example, a polypropylene-based resin, etc.), a (meth)acrylic-based resin, a (meth)acrylonitrile-based resin, a polyamide-based resin, a polycarbonate-based resin, a polyether-based resin, a polyester-based resin (for example, polyethylene naphthalate-based resin, PET-based resin, etc.), an epoxy-based resin, an organosiloxane-based resin, a polyimide-based resin, a polysulfone-based resin, etc.

The thickness of the substrate 2 may be, for example, at least 5 µm, at least 10 µm, at least 15 µm, or at least 20 µm. If the thickness of the substrate 2 is thick, the long-term reliability tends to improve. Additionally, the thickness of the substrate 2 may be, for example, at most 150 µm, at most 100 µm, at most 50 µm, or at most 40 µm. If the thickness of the substrate 2 is thin, the flexibility tends to improve. That is, the thickness of the substrate 2 may be, for example, 5-150 µm, 5-100 µm, 5-50 µm, 5-40 µm, 10-150 µm, 10-100 µm, 10-50 µm, 10-40 µm, 15-150 µm, 15-100 µm, 15-50 µm, 15-40 µm, 20-150 µm, 20-100 µm, 20-50 µm, or 20-40 µm.

The thermal conductivity of the substrate 2 may be, for example, at least 0.01 W/mK (corresponding to 0.1 watt per meter per Kelvin and to 0.1 W × m⁻¹ × K⁻¹), at least 0.05 W/mK, at least 0.1 W/mK, or at least 0.2 W/mK. If the thermal conductivity of the substrate 2 is high, thermal conduction from the thermally conductive portions 5 to the thermoelectric conversion groups 3 becomes faster. Additionally, the thermal conductivity of the substrate 2 may be, for example, at most 10 W/mK, at most 5 W/mK, at most 1 W/mK, or at most 0.5 W/mK. If the thermal conductivity of the substrate 2 is low, temperature differences more easily occur inside the thermoelectric conversion groups 3. The thermal conductivity of the substrate 2 is measured by the laser flash method. That is, the thermal conductivity of the substrate 2 may be, for example, 0.01-10 W/mK, 0.01-5 W/mK, 0.01-1 W/mK, 0.01-0.5 W/mK, 0.05-10 W/mK, 0.05-5 W/mK, 0.05-1 W/mK, 0.05-0.5 W/mK, 0.1-10 W/mK, 0.1-5 W/mK, 0.1-1 W/mK, 0.1-0.5 W/mK, 0.2-10 W/mK, 0.2-5 W/mK, 0.2-1 W/mK, or 0.2-0.5 W/mK.

The water vapor transmission rate in the thickness direction of the substrate 2 may be, for example, at most 100 g/(m²·day), at most 80 g/(m²·day), at most 60 g/(m²·day), at most 40 g/(m²·day), at most 20 g/(m²·day), or at most 10 g/(m²·day). If the water vapor transmission rate of the substrate 2 is low, the long-term reliability tends to improve. The lower limit of the water vapor transmission rate in the thickness direction of the substrate 2 is not particularly limited. The water vapor transmission rate in the thickness direction of the substrate 2 may be, for example, at least 0.1 g/(m²·day), at least 0.5 g/(m²·day), or at least 1 g/(m²·day). That is, the water vapor transmission rate in the thickness direction of the substrate 2 may be, for example, 0.1-100 g/(m²·day), 0.1-80 g/(m²·day), 0.1-60 g/(m²·day), 0.1-40 g/(m²·day), 0.1-20 g/(m²·day), 0.1-10 g/(m²·day), 0.5-100 g/(m²·day), 0.5-80 g/(m²·day), 0.5-60 g/(m²·day), 0.5-40 g/(m²·day), 0.5-20 g/(m²·day), 0.5-10 g/(m²·day), 1-100 g/(m²·day), 1-80 g/(m²·day), 1-60 g/(m²·day), 1-40 g/(m²·day), 1-20 g/(m²·day), or 1-10 g/(m²·day). The water vapor transmission rate of the substrate 2 is measured by the cup method.

The emissivity of the substrate 2 may be, for example, at least 0.70, at least 0.80, or at least 0.90. Additionally, the emissivity of the substrate 2 may be, for example, at most 0.99, at most 0.97, or at most 0.95. That is, the emissivity of the substrate 2 may be, for example, 0.70-0.99, 0.70-0.97, 0.70-0.95, 0.80-0.99, 0.80-0.97, 0.80-0.95, 0.90-0.99, 0.90-0.97, or 0.90-0.95. The emissivity of the substrate 2 is measured by an infrared thermography camera.

The substrate 2 has a first main surface 2a, and a second main surface 2b located on the side opposite to the first main surface 2a. The first main surface 2a and the second main surface 2b are surfaces that intersect with the direction along the thickness of the substrate 2. The shapes of the first main surface 2a and the second main surface 2b are not particularly limited and may be, for example, polygonal, circular, elliptical, etc. Hereinafter, the direction along the thickness of the substrate 2 will be expressed simply as the thickness direction D1. A view along the thickness direction D1 corresponds to a plan view. Additionally, the directions orthogonal to the thickness direction D1 will be defined as the first direction D2 and the second direction D3.

A thermoelectric conversion region R1 and two electrically conductive regions R2 are delimited on the first main surface 2a. The thermoelectric conversion region R1 is provided with a plurality of thermoelectric conversion groups 3. Each electrically conductive region R2 is provided with a plurality of electrically conductive portions 4. The thermoelectric conversion region R1 is located between the two electrically conductive regions R2 in the first direction D2. The higher the percentage of the first main surface 2a occupied by the thermoelectric conversion region R1 is, the higher the output power of the thermoelectric conversion module 1 tends to be. In plan view, the percentage of the area of the first main surface 2a occupied by the thermoelectric conversion region R1 is, for example, at least 50% and at most 90%. Additionally, in plan view, the percentage of the area of the first main surface 2a occupied by the two electrically conductive regions R2 is, for example, at least 5% and at most 30%. In this case, electrically conductive pathways connecting the thermoelectric conversion groups 3 with each other can be reliably formed, and the thermoelectric conversion module 1 can achieve good output power.

Each of the plurality of thermoelectric conversion groups 3 is a portion that can generate power by means of heat supplied from the outside, and is located on the first main surface 2a. The plurality of thermoelectric conversion groups 3 extend in the first direction D2 and are arranged in a row in the second direction D3. Each of the plurality of thermoelectric conversion groups 3 is band-shaped when viewed from the thickness direction D1. The thermoelectric conversion groups 3 are spaced apart from each other while also being electrically connected in series with each other. In the first direction D2, one end of each thermoelectric conversion groups 3 is connected with one of the plurality of electrically conductive portions 4 included in one of the electrically conductive regions R2, and the other end of each thermoelectric conversion groups 3 is connected with one of the plurality of electrically conductive portions 4 included in the other of the electrically conductive regions R2. Each of the plurality of thermoelectric conversion groups 3 has a plurality of thermoelectric conversion portions 11. In the present embodiment, each of the thermoelectric conversion groups 3 has ten thermoelectric conversion portions 11. However, there is no limitation thereto. In each of the thermoelectric conversion groups 3, the plurality of thermoelectric conversion portions 11 are arranged in a row in the first direction D2. Two thermoelectric conversion portions 11 that are adjacent to each other in the first direction D2 are in contact with each other and are serially connected.

Hereinafter, of the two thermoelectric conversion groups 3 illustrated in FIG. 3(a), one of the thermoelectric conversion groups 3 will sometimes be called the first thermoelectric conversion group 3a, and the other thermoelectric conversion group 3 adjacent to the first thermoelectric conversion group 3a in the second direction D3 will sometimes be called the second thermoelectric conversion group 3b. Additionally, the thermoelectric conversion portions 11 included in the first thermoelectric conversion group 3a will sometimes be called the first thermoelectric conversion portions 11a, and the thermoelectric conversion portions 11 included in the second thermoelectric conversion group 3b will sometimes be called the second thermoelectric conversion portions 11b. The plurality of first thermoelectric conversion portions 11a included in the first thermoelectric conversion group 3a are arranged sequentially in the first direction D2 and the plurality of second thermoelectric conversion portions 11b included in the second thermoelectric conversion group 3b are arranged sequentially in the first direction D2. The first thermoelectric conversion portions 11a and the second thermoelectric conversion portions 11b are adjacent to each other in the second direction D3.

Each of the plurality of thermoelectric conversion portions 11 is a portion, exhibiting flexibility, in which thermoelectric conversion is implemented in the thermoelectric conversion module 1. Although the shapes of the thermoelectric conversion portions 11 in plan view are not particularly limited, they may be, for example, polygonal, circular, elliptical, etc. A p-type thermoelectric conversion element 21 and an n-type thermoelectric conversion element 22 have the same shape as each other. However, there is no limitation thereto. Each thermoelectric conversion portion 11 has a p-type thermoelectric conversion element 21 and an n-type thermoelectric conversion element 22 lying side by side in the first direction D2. In each thermoelectric conversion portion 11, a first end 21a of the p-type thermoelectric conversion element 21 in the first direction D2 and a first end 22a of the n-type thermoelectric conversion element 22 in the first direction D2 are in contact with each other. In each thermoelectric conversion portion 11, a second end 21b of the p-type thermoelectric conversion element 21 in the first direction D2 is located at one end of the corresponding thermoelectric conversion portion 11, and a second end 22b of the n-type thermoelectric conversion element 22 in the first direction D2 is located at the other end of the corresponding thermoelectric conversion portion 11. For two thermoelectric conversion portions 11 that are adjacent to each other in the first direction D2, the second end 21b of the p-type thermoelectric conversion element 21 included on one of the thermoelectric conversion portions 11 and the second end 22b of the n-type thermoelectric conversion element 22 included on the other of the thermoelectric conversion portions 11 are in contact with each other.

In each of the plurality of thermoelectric conversion groups 3, p-type thermoelectric conversion elements 21 and n-type thermoelectric conversion elements 22 are arranged in an alternating manner in the first direction D2. As illustrated in FIG. 3(a), in the present embodiment, the p-type thermoelectric conversion element 21 of a first thermoelectric conversion portion 11a and the n-type thermoelectric conversion element 22 (second n-type thermoelectric conversion element) of a second thermoelectric conversion portion 11b lie adjacent to each other in the second direction D3, and the n-type thermoelectric conversion element 22 of the first thermoelectric conversion portion 11a and the p-type thermoelectric conversion element 21 (second p-type thermoelectric conversion element) of the second thermoelectric conversion portion 11b lie adjacent to each other in the second direction D3.

The p-type thermoelectric conversion elements 21 are provided on the first main surface 2a of the substrate 2 and are in contact with the n-type thermoelectric conversion elements 22.

The thickness T1 of the p-type thermoelectric conversion elements 21 may be, for example, at least 3 µm, at least 5 µm, at least 8 µm, or at least 10 µm. If the thickness T1 of the p-type thermoelectric conversion elements 21 is large, the electrical resistance of the p-type thermoelectric conversion elements 21 is further reduced. The thickness T1 of the p-type thermoelectric conversion elements 21 may be, for example, at most 30 µm, at most 25 µm, at most 20 µm, or at most 15 µm. If the thickness T1 of the p-type thermoelectric conversion elements 21 is small, temperature gradients easily form inside the p-type thermoelectric conversion elements 21, allowing higher output power to be stably obtained more easily. That is, the thickness T1 of the p-type thermoelectric conversion elements 21 may be, for example, 3-30 µm, 3-25 µm, 3-20 µm, 3-15 µm, 5-30 µm, 5-25 µm, 5-20 µm, 5-15 µm, 8-30 µm, 8-25 µm, 8-20 µm, 8-15 µm, 10-30 µm, 10-25 µm, 10-20 µm, or 10-15 µm.

The length L1 of the p-type thermoelectric conversion elements 21 in the first direction D2 may be, for example, at least 2 mm, at least 3 mm, or at least 5 mm. If the length L1 of the p-type thermoelectric conversion elements 21 is long, temperature gradients easily form inside the p-type thermoelectric conversion elements 21, allowing higher output power to be stably obtained more easily. Additionally, the length L1 of the p-type thermoelectric conversion elements 21 in the first direction D2 may be, for example, at most 10 mm, at most 9 mm, or at most 7 mm. If the length L1 of the p-type thermoelectric conversion elements 21 is short, more of the thermoelectric conversion portions 11 can be formed on the first main surface 2a. That is, the length L1 of the p-type thermoelectric conversion elements 21 in the first direction D2 may be, for example, 2-10 mm, 2-9 mm, 2-7 mm, 3-10 mm, 3-9 mm, 3-7 mm, 5-10 mm, 5-9 mm, or 5-7 mm.

The length of the p-type thermoelectric conversion elements 21 in the second direction D3 may be, for example, at least 0.1 mm, at least 0.5 mm, or at least 1 mm. If the length of the p-type thermoelectric conversion elements 21 in the second direction D3 is long, the electrical resistance of the p-type thermoelectric conversion elements 21 is reduced. Additionally, the length of the p-type thermoelectric conversion elements 21 in the second direction D3 may be, for example, at most 20 mm, at most 10 mm, or at most 5 mm. If the length of the p-type thermoelectric conversion elements 21 in the second direction D3 is short, more thermoelectric conversion portions 11 can be formed on the first main surface 2a. That is, the length of the p-type thermoelectric conversion elements 21 in the second direction D3 may be, for example, 0.1-20 mm, 0.1-10 mm, 0.1-5 mm, 0.5-20 mm, 0.5-10 mm, 0.5-5 mm, 1-20 mm, 1-10 mm, or 1-5 mm.

The thermal conductivity of the p-type thermoelectric conversion elements 21 in the in-plane direction may be, for example, at most 50 W/mK, at most 40 W/mK, at most 30 W/mK, or at most 20 W/mK. If the thermal conductivity of the p-type thermoelectric conversion elements 21 in the in-plane direction is low, temperature differences more easily occur, and this is therefore preferable. The lower limit of the thermal conductivity of the p-type thermoelectric conversion elements 21 in the in-plane direction is not particularly limited. The thermal conductivity of the p-type thermoelectric conversion elements 21 in the in-plane direction may be, for example, at least 0.01 W/mK, at least 0.5 W/mK, or at least 1 W/mK. That is, the thermal conductivity of the p-type thermoelectric conversion elements 21 in the in-plane direction may be, for example, 0.01-50 W/mK, 0.01-40 W/mK, 0.01-30 W/mK, 0.01-20 W/mK, 0.5-50 W/mK, 0.5-40 W/mK, 0.5-30 W/mK, 0.5-20 W/mK, 1-50 W/mK, 1-40 W/mK, 1-30 W/mK, or 1-20 W/mK.

The p-type thermoelectric conversion elements 21 may be formed, for example, by various types of dry methods or wet methods. Wet methods include, for example, a doctor blade method, a dip coating method, a spray coating method, a spin coating method, an inkjet method, etc.

The p-type thermoelectric conversion elements 21 are, for example, p-type semiconductor layers. The p-type thermoelectric conversion elements 21 comprise, for example, carbon nanotubes (CNTs) and an electrically conductive resin different from the carbon nanotubes. The carbon nanotubes exhibit p-type conductivity. The carbon nanotubes may be any one of single-walled, double-walled, and multi-walled. From the aspect of the electrical conductivity of the p-type thermoelectric conversion elements 21, single-walled carbon nanotubes (SWCNTs) may be used. The percentage of the single-walled carbon nanotubes with respect to the overall amount of carbon nanotubes may be at least 25% by mass, at least 50% by mass, or at least 100% by mass. The diameter of the single-walled carbon nanotubes is not particularly limited, but may be, for example, at most 20 nm, at most 10 nm, or at most 3 nm. The lower limit of the diameter of the single-walled carbon nanotubes is also not particularly limited, but may be, for example, at least 0.4 nm or at least 0.5 nm. The thermal conductivity of the carbon nanotubes may be, for example, at least 30 W/mK and at most 40 W/mK.

In the present description, the diameter of the single-walled carbon nanotubes can be determined from the wavelength (ω (cm⁻¹)) of a peak appearing at 100-300 cm⁻¹ by Raman spectroscopy, using the following equation: "diameter (nm) = 248/ω". As a method for evaluating single-walled carbon nanotubes, the G/D ratio in laser Raman spectroscopy is known. In the present embodiment, the single-walled carbon nanotubes may have a G/D ratio of at least 10 or at least 20 in laser Raman spectroscopy at a wavelength of 532 nm. By using such single-walled carbon nanotubes, p-type thermoelectric conversion elements 21 with superior electrical conductivity tend to be obtained. The upper limit of the G/D ratio is not particularly limited, and may be at most 500 or at most 300.

The carbon nanotube content in the p-type thermoelectric conversion elements 21 may be, for example, at least 20 parts by mass, at least 30 parts by mass, or at least 40 parts by mass with respect to 100 parts by mass of the material (p-type thermoelectric conversion material) constituting the p-type thermoelectric conversion elements 21. Additionally, the carbon nanotube content in the p-type thermoelectric conversion elements 21 may be, for example, at most 99 parts by mass, at most 95 parts by mass, or at most 90 parts by mass with respect to 100 parts by mass of the material (p-type thermoelectric conversion material) constituting the p-type thermoelectric conversion elements 21. That is, the carbon nanotube content in the p-type thermoelectric conversion elements 21 may be, for example, 20-99 parts by mass, 20-95 parts by mass, 20-90 parts by mass, 30-99 parts by mass, 30-95 parts by mass, 30-90 parts by mass, 40-99 parts by mass, 40-95 parts by mass, or 40-90 parts by mass with respect to 100 parts by mass of the material (p-type thermoelectric conversion material) constituting the p-type thermoelectric conversion elements 21.

The electrically conductive resin in the present embodiment is not particularly limited, and known electrically conductive resins can be used without any particular restrictions. Electrically conductive resins include, for example, polyaniline-based electrically conductive resins, polythiophene-based electrically conductive resins, polypyrrole-based electrically conductive resins, polyacetylene-based electrically conductive resins, polyphenylene-based electrically conductive resins, polyphenylenevinylene-based electrically conductive resins, etc.

Polythiophene-based electrically conductive resins include, for example, poly(3,4-ethylenedioxythiophene) (PEDOT).

In the present embodiment, the electrically conductive resin may include a polythiophene-based electrically conductive resin and an electron receptor. In this case, the effects of the encapsulation layer 8 are enhanced. Electron receptors include polystyrene sulfonic acid (PSS), polyvinyl sulfonic acid, poly(meth)acrylic acid, polyvinyl sulfonic acid, toluene sulfonic acid, dodecylbenzene sulfonic acid, camphor sulfonic acid, bis(2-ethylhexyl) sulfosuccinate, chlorine, bromine, iodine, phosphorus pentafluoride, arsenic pentafluoride, boron trifluoride, hydrogen chloride, sulfuric acid, nitric acid, tetrafluoroboric acid, perchloric acid, ferric chloride, tetracyanoquinodimethane, etc.

The content ratio (mass ratio) of the electron receptor with respect to the polythiophene-based electrically conductive resin may be, for example, at least 1, at least 1.2, at least 1.3, or at least 1.5. Additionally, the content ratio (mass ratio) of the electron receptor with respect to the polythiophene-based electrically conductive resin may be, for example, at most 40, at most 30, at most 25, or at most 20. That is, the content ratio (mass ratio) of the electron receptor with respect to the polythiophene-based electrically conductive resin may be, for example, 1-40, 1-30, 1-25, 1-20, 1.2-40, 1.2-30, 1.2-25, 1.2-20, 1.3-40, 1.3-30, 1.3-25, 1.3-20, 1.5-40, 1.5-30, 1.5-25, or 1.5-20.

In the p-type thermoelectric conversion elements 21, the carbon nanotubes and the electrically conductive resin may be aggregated. The p-type thermoelectric conversion elements 21 may include porous structures in which carbon nanotubes are bonded to each other by the electrically conductive resin.

The n-type thermoelectric conversion elements 22 are provided on the first main surface 2a of the substrate 2 and are in contact with the p-type thermoelectric conversion elements 21.

The thickness of the n-type thermoelectric conversion elements 22 may be, for example, at least 3 µm, at least 5 µm, at least 8 µm, or at least 10 µm. If the thickness of the n-type thermoelectric conversion elements 22 is large, the electrical resistance of the n-type thermoelectric conversion elements 22 is further reduced. The thickness of the n-type thermoelectric conversion elements 22 may be, for example, at most 30 µm, at most 25 µm, at most 20 µm, or at most 15 µm. If the thickness of the n-type thermoelectric conversion elements 22 is small, temperature gradients easily form inside the n-type thermoelectric conversion elements 22, allowing higher output power to be stably obtained more easily. That is, the thickness of the n-type thermoelectric conversion elements 22 may be, for example, 3-30 µm, 3-25 µm, 3-20 µm, 3-15 µm, 5-30 µm, 5-25 µm, 5-20 µm, 5-15 µm, 8-30 µm, 8-25 µm, 8-20 µm, 8-15 µm, 10-30 µm, 10-25 µm, 10-20 µm, or 10-15 µm. The thickness of the n-type thermoelectric conversion elements 22 may be the same as or substantially the same as the thickness T1 of the p-type thermoelectric conversion elements 21.

The length of the n-type thermoelectric conversion elements 22 in the first direction D2 may be, for example, at least 2 mm, at least 3 mm, or at least 5 mm. If the length of the n-type thermoelectric conversion elements 22 is long, temperature gradients easily form inside the n-type thermoelectric conversion elements 22, allowing higher output power to be stably obtained more easily. Additionally, the length of the n-type thermoelectric conversion elements 22 in the first direction D2 may be, for example, at most 10 mm, at most 9 mm, or at most 7 mm. If the length of the n-type thermoelectric conversion elements 22 is short, more of the thermoelectric conversion portions 11 can be formed on the first main surface 2a. That is, the length of the n-type thermoelectric conversion elements 22 in the first direction D2 may be, for example, 2-10 mm, 2-9 mm, 2-7 mm, 3-10 mm, 3-9 mm, 3-7 mm, 5-10 mm, 5-9 mm, or 5-7 mm. The length of the n-type thermoelectric conversion elements 22 in the first direction D2 may be the same as or substantially the same as the length L1 of the p-type thermoelectric conversion elements 21.

The length of the n-type thermoelectric conversion elements 22 in the second direction D3 may be, for example, at least 0.1 mm, at least 0.5 mm, or at least 1 mm. If the length of the n-type thermoelectric conversion elements 22 in the second direction D3 is long, the electrical resistance of the n-type thermoelectric conversion elements 22 is further reduced. Additionally, the length of the n-type thermoelectric conversion elements 22 in the second direction D3 may be, for example, at most 20 mm, at most 10 mm, or at most 5 mm. If the length of the n-type thermoelectric conversion elements 22 in the second direction D3 is short, more thermoelectric conversion portions 11 can be formed on the first main surface 2a. That is, the length of the n-type thermoelectric conversion elements 22 in the second direction D3 may be, for example, 0.1-20 mm, 0.1-10 mm, 0.1-5 mm, 0.5-20 mm, 0.5-10 mm, 0.5-5 mm, 1-20 mm, 1-10 mm, or 1-5 mm. The length of the n-type thermoelectric conversion elements 22 in the second direction D3 may be the same as or substantially the same as the length of the p-type thermoelectric conversion elements 21 in the second direction D3.

The thermal conductivity of the n-type thermoelectric conversion elements 22 in the in-plane direction may be, for example, at most 50 W/mK, at most 40 W/mK, at most 30 W/mK, or at most 20 W/mK. If the thermal conductivity of the n-type thermoelectric conversion elements 22 in the in-plane direction is low, temperature differences more easily occur. The lower limit of the thermal conductivity of the n-type thermoelectric conversion elements 22 in the in-plane direction is not particularly limited. The thermal conductivity of the n-type thermoelectric conversion elements 22 in the in-plane direction may be, for example, at least 0.01 W/mK, at least 0.5 W/mK, or at least 1 W/mK. That is, the thermal conductivity of the n-type thermoelectric conversion elements 22 in the in-plane direction may be, for example, 0.01-50 W/mK, 0.01-40 W/mK, 0.01-30 W/mK, 0.01-20 W/mK, 0.5-50 W/mK, 0.5-40 W/mK, 0.5-30 W/mK, 0.5-20 W/mK, 1-50 W/mK, 1-40 W/mK, 1-30 W/mK, or 1-20 W/mK. The thermal conductivity of the n-type thermoelectric conversion elements 22 in the in-plane direction is measured, for example, by the optical AC method, the three-omega method, or the laser flash method.

The n-type thermoelectric conversion elements 22, like the p-type thermoelectric conversion elements 21, are formed, for example, by various wet methods or dry methods.

The n-type thermoelectric conversion elements 22 are, for example, n-type semiconductor layers. The n-type thermoelectric conversion elements 22 include, for example, composites of a plurality of organic substances, or composites of inorganic substances and organic substances. In the present embodiment, the n-type thermoelectric conversion elements 22 may be portions exhibiting n-type conductivity due to doping the p-type thermoelectric conversion elements 21 with a dopant. For this reason, the n-type thermoelectric conversion elements 22 may include carbon nanotubes, an electrically conductive resin, and a dopant. Examples of the carbon nanotubes and the electrically conductive resin in the n-type thermoelectric conversion elements 22 are the same as those for the carbon nanotubes and the electrically conductive resin in the p-type thermoelectric conversion elements 21.

Dopants refer to substances that change the Seebeck coefficient in portions that are doped with the dopant. To "change the Seebeck coefficient" means to reduce the value of the Seebeck coefficient or to change the value of the Seebeck coefficient from a positive value to a negative value. A thermoelectric conversion material in which the Seebeck coefficient exhibits a positive value has p-type conductivity, and a thermoelectric conversion material in which the Seebeck coefficient exhibits a negative value has n-type conductivity.

The dopant in the present embodiment may contain, for example, a cation scavenger (hereinafter sometimes referred to simply as "scavenger") and a complex salt that can be dissociated into an anion that is a complex ion (hereinafter sometimes referred to simply as "anion") and an alkali metal cation (hereinafter sometimes referred to simply as "cation"). The n-type thermoelectric conversion elements 22 formed by such a dopant can obtain excellent thermoelectric conversion performance. Additionally, due to the n-type thermoelectric conversion elements 22 being formed by such a dopant, the long-term reliability improvement effects due to the encapsulation layer 8 are enhanced.

Inside the n-type thermoelectric conversion elements 22, at least some of the complex salts may be dissociated into the above-mentioned anions and the above-mentioned cations. In this case, the above-mentioned cations may be scavenged by the above-mentioned scavenger. The dopant may comprise a plurality of types of at least one of the complex salt and the scavenger. In the portions of the p-type thermoelectric conversion elements 21 that are doped with the above-mentioned dopant, the Seebeck coefficient changes. As a result thereof, the n-type thermoelectric conversion elements 22 are formed in the above-mentioned portions.

Though the reasons that the above-mentioned effects are achieved are not particularly limited, one factor may be that the scavenger contained in the dopant scavenges the cations and thereby dissociates the anions, and the anions change carriers in the carbon nanotubes from holes to electrons. In this case, in the present embodiment, the anions are complex ions having metal atoms at the centers thereof, and therefore, the interactions between the metal atoms and the carbon nanotubes can be considered to enhance the conversion to n-type conductivity. Additionally, one factor in achieving the above-mentioned effects can be considered to be that the complex ions have a large ion size and therefore have good dissociation properties with respect to cations scavenged by the scavenger. In the dopant of the present embodiment, the anions are complex ions. For this reason, the n-type thermoelectric conversion elements 22 comprise metal atoms derived from the complex ions. For this reason, in the present embodiment, the metal atoms remaining in the n-type thermoelectric conversion elements 22 can function as antioxidants.

The obtained complex ions (anions) may be selected from the group consisting of ferrocyanide ions, ferricyanide ions, tetrachloroferrate(III) ions, tetrachloroferrate(II) ions, tetracyanonickelate(II) ions, tetrachloronickelate(II) ions, tetracyanocobaltate(II) ions, tetrachlorocobaltate(II) ions, tetracyanocuprate(I) ions, tetrachlorocuprate(II) ions, hexacyanochromate(III) ions, tetrahydroxidozincate(II) ions, and tetrahydroxidoaluminate(III) ions. Among the above, ferrocyanide ions are preferable. If the above-mentioned anions are ferrocyanide ions, an n-type thermoelectric conversion material having more favorable characteristics tends to be obtained. Additionally, when the anions are ferrocyanide ions, the iron atoms remaining in the n-type thermoelectric conversion elements 22 function suitably as antioxidants, changes in physical properties due to the passage of time are more suppressed, and the storage stability tends to improve.

The above-mentioned anions may include iron atoms. That is, the complex salts may include iron atoms. In this case, the anions may be selected, for example, from the group consisting of ferrocyanide ions, ferricyanide ions, tetrachloroferrate(III) ions, and tetrachloroferrate(ll) ions. From the aspect of the characteristics of the n-type thermoelectric conversion elements 22, the above-mentioned anions including iron atoms may be ferrocyanide ions. From the aspect of antioxidant effects, the iron atom content in the n-type thermoelectric conversion elements 22 may be at least 0.001% by mass and at most 15% by mass, at least 0.005% by mass and 12% by mass, and at least 0.01% by mass and at most 10% by mass. The iron atom content in the n-type thermoelectric conversion elements 22 indicate a value measured, for example, by ICP spectrometry.

Complex salts include potassium ferrocyanide, sodium ferrocyanide, potassium ferricyanide, sodium ferricyanide, potassium tetrachloroferrate(III), sodium tetrachloroferrate(III), potassium tetrachloroferrate(II), sodium tetrachloroferrate(II), etc. The complex salts may be anhydrides.

Alkali metal cations include sodium ions, potassium ions, lithium ions, etc.

The cation scavengers are not particularly limited as long as they are substances having the capacity to take in cations. The cation scavengers are, for example, crown ether compounds, cyclodextrin, calixarene, ethylenediaminetetraacetic acid, porphyrin, phthalocyanine, derivatives thereof, etc.

In the present embodiment, the cation scavenger may be a crown ether compound. Crown ether compounds include 15-crown-5-ether, 18-crown-6-ether, 12-crown-4-ether, benzo-18-crown-6-ether, benzo-15-crown-5-ether, benzo-12-crown-4-ether, etc. For the crown ether used as the scavenger, the size of the ring may be selected in accordance with the size of the metal ion to be taken in. For example, if the metal ion is a potassium ion, the crown ether compound may be a crown ether that is an 18-membered ring. If the metal ion is a sodium ion, the crown ether compound may be a crown ether that is a 15-membered ring. If the metal ion is a lithium ion, the crown ether compound may be a crown ether that is a 12-membered ring.

The crown ether compound may include a benzene ring. In this case, the stability of the crown ether compound may improve. Crown ether compounds having benzene rings include benzo-18-crown-6-ether, benzo-15-crown-5-ether, benzo-12-crown-4-ether, etc.

The molar ratio (C₂/C₁) of the scavenger content C₂ to the cation content C₁ may be, for example, at least 0.1, at least 0.3, or at least 0.5. Additionally, the molar ratio (C₂/C₁) of the scavenger content C₂ to the cation content C₁ may be, for example, at most 5, at most 3, or at most 2. That is, the molar ratio (C₂/C₁) may be, for example, 0.1-5, 0.1-3, 0.1-2, 0.3-5, 0.3-3, 0.3-2, 0.5-5, 0.5-3, or 0.5-2.

Each of the plurality of electrically conductive portions 4 is an electrically conductive portion located on the first main surface 2a and is connected to a corresponding thermoelectric conversion group 3. The electrically conductive portions 4 may be electrical conductors or may be semiconductors. The electrical conductivity of the electrically conductive portions 4 may be about the same as the electrical conductivity of the p-type thermoelectric conversion elements 21 or may be equal to or higher than the electrical conductivity of the p-type thermoelectric conversion elements 21.

The thickness of each electrically conductive portion 4 may be, for example, at least 3 µm, at least 5 µm, at least 8 µm, or at least 10 µm. Additionally, the thickness of each electrically conductive portion 4 may be, for example, at most 30 µm, at most 25 µm, at most 20 µm, or at most 15 µm. That is, the thickness of each electrically conductive portion 4 may be, for example, 3-30 µm, 3-25 µm, 3-20 µm, 3-15 µm, 5-30 µm, 5-25 µm, 5-20 µm, 5-15 µm, 8-30 µm, 8-25 µm, 8-20 µm, 8-15 µm, 10-30 µm, 10-25 µm, 10-20 µm, or 10-15 µm. The thickness of each electrically conductive portion 4 may be the same as or substantially the same as the thickness T1 of the p-type thermoelectric conversion elements 21.

The thermal conductivity of each electrically conductive portion 4 may be, for example, at least 0.01 W/mK, at least 0.5 W/mK, at least 1 W/mK, at least 3 W/mK, or at least 10 W/mK. Additionally, the thermal conductivity of each electrically conductive portion 4 may be, for example, at most 50 W/mK, at most 40 W/mK, at most 30 W/mK, or at most 20 W/mK. That is, the thermal conductivity of each electrically conductive portion 4 may be, for example, 0.01-50 W/mK, 0.01-40 W/mK, 0.01-30 W/mK, 0.01-20 W/mK, 0.5-50 W/mK, 0.5-40 W/mK, 0.5-30 W/mK, 0.5-20 W/mK, 1-50 W/mK, 1-40 W/mK, 1-30 W/mK, 1-20 W/mK, 3-50 W/mK, 3-40 W/mK, 3-30 W/mK, 3-20 W/mK, 10-50 W/mK, 10-40 W/mK, 10-30 W/mK, or 10-20 W/mK. The thermal conductivity of each electrically conductive portion 4 may be the same as the thermal conductivity of the p-type thermoelectric conversion elements 21 or may be equal to or higher than the thermal conductivity of the p-type thermoelectric conversion elements 21.

At least some of the plurality of electrically conductive portions 4 may have a single-layered structure, or may have a laminated structure. For example, at least some of the plurality of electrically conductive portions 4 may have an organic electrically conductive layer, and a metal electrically conductive layer located on said organic electrically conductive layer.

In the present embodiment, the plurality of electrically conductive portions 4 may be formed from the same material as the p-type thermoelectric conversion elements 21. For this reason, each of the electrically conductive portions 4 may have the same conductivity type (p type).

The plurality of electrically conductive portions 4 have first electrically conductive portions 4a that function as terminals for connecting external devices and second electrically conductive portions 4b that function as electrically conductive pathways for connecting adjacent thermoelectric conversion groups with each other. The plurality of electrically conductive portions 4 have two first electrically conductive portions 4a, the two first electrically conductive portions 4a being located within one of the electrically conductive regions R2. The other of the electrically conductive regions R2 is provided with only a second electrically conductive portion 4b.

The plurality of thermoelectric conversion groups 3 are serially connected to each other by the plurality of second electrically conductive portions 4b. For this reason, when the thermoelectric conversion module 1 implements thermoelectric conversion, electric current can flow in series from one of the first electrically conductive portions 4a to another of the first electrically conductive portions 4a. For example, one of the first electrically conductive portions 4a located in one of the electrically conductive regions R2 is connected to one end of a first thermoelectric conversion group 3a in the first direction D2, and one of the second electrically conductive portions 4b located in the other of the electrically conductive regions R2 is connected to the other end of the first thermoelectric conversion groups 3a and to one end of a second thermoelectric conversion group 3b in the first direction D2.

The plurality of thermally conductive portions 5 are portions exhibiting higher thermal conductivity than the substrate 2, and is located on the second main surface 2b. At least some of the plurality of thermally conductive portions 5 overlap with the thermoelectric conversion groups 3 (i.e., the thermoelectric conversion portions 11) in the thickness direction D1. More specifically, at least some of the plurality of thermally conductive portions 5 overlap with the ends of the thermoelectric conversion portions 11. However, the thermally conductive portions 5 do not overlap with the centers of the thermoelectric conversion portions 11. As a result thereof, temperature gradients can be favorably generated inside the thermoelectric conversion portions 11 in the first direction D2. The plurality of thermally conductive portions 5 are spaced apart from each other in the first direction D2 and are band-shaped so as to extend in the second direction in plan view. The shape of each thermally conductive portion 5 in plan view is not particularly limited, and may be, for example, polygonal, circular, elliptical, etc. The thermally conductive portions 5 include, for example, metal (silver, copper, etc.), carbon, resin (for example, silicone resin, epoxy resin, (meth)acrylic resin), etc. The thermally conductive portions 5 may include ceramics such as boron nitride, aluminum nitride, etc. exhibiting high thermal conductivity. From the aspect of manufacturing efficiency, the thermally conductive portions 5 may include one of the above-mentioned resins. In this case, the thermally conductive portions 5 may be formed by using said resin or a solution containing said resin.

The thermal conductivity of each thermally conductive portion 5 may be, for example, at least 1 W/mK, at least 2 W/mK, at least 3 W/mK, at least 5 W/mK, or at least 10 W/mK. If the thermal conductivity of each thermally conductive portion 5 is high, the transfer of heat to the thermoelectric conversion portions 11 through the plurality of thermally conductive portions 5 when the thermoelectric conversion module 1 is heated progresses more easily. The thermal conductivity of each thermally conductive portion 5 may be, for example, at most 400 W/mK, at most 300 W/mK, or at most 200 W/mK. That is, the thermal conductivity of each thermally conductive portion 5 may be, for example, 1-400 W/mK, 1-300 W/mK, 1-200 W/mK, 2-400 W/mK, 2-300 W/mK, 2-200 W/mK, 3-400 W/mK, 3-300 W/mK, 3-200 W/mK, 5-400 W/mK, 5-300 W/mK, 5-200 W/mK, 10-400 W/mK, 10-300 W/mK, or 10-200 W/mK. The thermal conductivity of the thermally conductive portions 5 is measured by a steady-state method or by a non-steady-state method.

The linear expansion coefficient in the in-plane direction of each thermally conductive portion 5 may be, for example, at least 1 ppm/K, at least 10 ppm/K, or at least 50 ppm/K. Additionally, the linear expansion coefficient in the in-plane direction of each thermally conductive portion 5 may be, for example, at most 200 ppm/K, at most 150 ppm/K, or at most 100 ppm/K. That is, the linear expansion coefficient in the in-plane direction of each thermally conductive portion 5 may be, for example, 1-200 ppm/K, 1-150 ppm/K, 1-100 ppm/K, 10-200 ppm/K, 10-150 ppm/K, 10-100 ppm/K, 50-200 ppm/K, 50-150 ppm/K, or 50-100 ppm/K. The linear expansion coefficient of each thermally conductive portions 5 is measured, for example, by thermomechanical analysis (TMA).

The length T2 of each thermally conductive portion 5 in the thickness direction D1 may be, for example, at least 50 µm, at least 100 µm, or at least 200 µm. If the length T2 is long, temperature differences more easily occur. Additionally, the length T2 of each thermally conductive portion 5 in the thickness direction D1 may be, for example, at most 2000 µm, at most 1700 µm, or at most 1500 µm. If the length T2 is short, the module tends to become thin and compact. That is, the length T2 of each thermally conductive portion 5 in the thickness direction D1 may be, for example, 50-200 µm, 50-1700 µm, 50-1500 µm, 100-2000 µm, 100-1700 µm, 100-1500 µm, 200-2000 µm, 200-1700 µm, or 200-1500 µm.

The width L2 of each thermally conductive portion 5 in the first direction D2 may be, for example, at least 0.2 mm, at least 0.5 mm, or at least 0.8 mm. If the width L2 is large, the thermal conduction function due to each thermally conductive portion 5 can be favorably achieved. Additionally, the width L2 of each thermally conductive portion 5 in the first direction D2 may be, for example, at most 2.0 mm, at most 1.8 mm, or at most 1.5 mm. If the width L2 is small, temperature differences can be more favorably generated inside the thermoelectric conversion portions 11. That is, the width L2 of each thermally conductive portion 5 in the first direction D2 may be, for example, 0.2-2.0 mm, 0.2-1.8 mm, 0.2-1.5 mm, 0.5-2.0 mm, 0.5-1.8 mm, 0.5-1.5 mm, 0.8-2.0 mm, 0.8-1.8 mm, or 0.8-1.5 mm.

In two thermally conductive portions 5 that are adjacent to each other, the spacing S in the first direction D2 is greater than the length L1 of the p-type thermoelectric conversion elements 21 in the first direction D2 and the length of the n-type thermoelectric conversion elements 22 in the first direction D2. The spacing S may be, for example, at least 3 mm, at least 4 mm, at least 5 mm, or at least 6 mm. If the spacing S is large, temperature gradients can more favorably be generated inside the thermoelectric conversion portions 11. Additionally, the spacing S may be, for example, at most 15 mm, at most 12 mm, at most 10 mm, or at most 8 mm. If the spacing S is small, more thermoelectric conversion portions 11 can be formed on the first main surface 2a. That is, the spacing S may be, for example, 3-15 mm, 3-12 mm, 3-10 mm, 3-8 mm, 4-15 mm, 4-12 mm, 4-10 mm, 4-8 mm, 5-15 mm, 5-12 mm, 5-10 mm, 5-8 mm, 6-15 mm, 6-12 mm, 6-10 mm, or 6-8 mm.

Hereinafter, of the two thermally conductive portions 5 illustrated in FIG. 3(b), one of the thermally conductive portions 5 will sometimes be called a first thermally conductive portion 5a, and the other of the thermally conductive portions 5 adjacent to the first thermally conductive portion 5a in the first direction D2 will sometimes be called the second thermally conductive portion 5b. In this case, the first thermally conductive portion 5a overlaps, in the thickness direction D1, with one end of the first thermoelectric conversion portion 11a in the first direction D2. Additionally, the second thermally conductive portion 5b overlaps, in the thickness direction D1, with the other end of the first thermoelectric conversion portion 11a in the first direction D2. More specifically, in the thickness direction D1, the first thermally conductive portion 5a overlaps with the second end 22b of the n-type thermoelectric conversion element 22 included in the first thermoelectric conversion portion 11a, and the second thermally conductive portion 5b overlaps with the second end 21b of the p-type thermoelectric conversion element 21 included in the first thermoelectric conversion portion 11a. Additionally, as illustrated in FIG. 3(a), in the thickness direction D1, the first thermally conductive portion 5a overlaps with the second end 21b of the p-type thermoelectric conversion element 21 included in the second thermoelectric conversion portion 11b, and the second thermally conductive portion 5b overlaps with the second end 22b of the n-type thermoelectric conversion element 22 included in the second thermoelectric conversion portion 11b.

The plurality of thermally insulating members 6 are portions exhibiting a thermal conductivity equal to or lower than the thermal conductivity of the substrate 2 (preferably lower than the thermal conductivity of the substrate 2). Each of the plurality of thermally insulating members 6 is located between a first thermally conductive portion 5a and a second thermally conductive portion 5b corresponding thereto. The plurality of thermally insulating members 6 are spaced apart from each other in the first direction D2. Although the shape of each thermally insulating member 6 in plan view is not particularly limited, the shape is, for example, polygonal, circular, elliptical, etc. In the present embodiment, each thermally insulating member 6 is band-shaped so as to extend in the second direction in plan view, and contacts both the first thermally conductive portion 5a and the second thermally conductive portion 5b corresponding thereto. For this reason, the width of each thermally insulating member 6 in the first direction D2 in the present embodiment corresponds to the spacing S.

The length T3 of each thermally insulating member 6 in the thickness direction D1 is smaller than the length T2 of each thermally conductive portion 5. For example, the length T3 may be at most 95%, or at most 80% of the length T2. In this case, the thermally insulating member 6 tends not to peel from the substrate 2 when the thermoelectric conversion module 1 is deformed. Additionally, the length T3 may be at least 5% or at least 10% of the length T2. That is, the length T3 may be, for example, 5-95%, 5-80%, 10-95%, or 10-80% of the length T2.

At least part of each of the plurality of thermally insulating members 6 overlaps with the center of a corresponding thermoelectric conversion portion 11 in the thickness direction D1. In other words, in each thermoelectric conversion portion 11, the first end 21a of a p-type thermoelectric conversion element 21 and the first end 22a of an n-type thermoelectric conversion element 22 at least partially overlap with each of the plurality of thermally insulating members 6 in the thickness direction D1. As a result thereof, the temperature at the central part of each thermoelectric conversion portion 11 can be stabilized. Therefore, temperature gradients tend to be stably generated inside the thermoelectric conversion portions 11 in the first direction D2.

Each of the thermally insulating members 6 may, for example, include cellulose nanofibers (CNFs), a silica aerogel, a resin (for example, silicone), etc. Each of the thermally insulating members 6 may be a foamed body.

The thermal conductivity of each thermally insulating member 6 may be, for example, at least 0.01 W/mK, at least 0.02 W/mK, or at least 0.03 W/mK. Additionally, the thermal conductivity of each thermally insulating member 6 may be, for example, at most 0.1 W/mK, at most 0.08 W/mK, or at most 0.05 W/mK. That is, the thermal conductivity of each thermally insulating member 6 may be, for example, 0.01-0.1 W/mK, 0.01-0.08 W/mK, 0.01-0.05 W/mK, 0.02-0.1 W/mK, 0.02-0.08 W/mK, 0.02-0.05 W/mK, 0.03-0.1 W/mK, 0.03-0.08 W/mK, or 0.03-0.05 W/mK. The thermal conductivity of each thermally insulating member 6 may be equal to or lower than the thermal conductivity of the substrate 2, or may be lower than the thermal conductivity of the substrate 2.

The linear expansion coefficient of each thermally insulating member 6 may be, for example, at most 200 ppm/K, at most 180 ppm/K, or at most 150 ppm/K. Additionally, the linear expansion coefficient of each thermally insulating member 6 may be, for example, at least 0.1 ppm/K, at least 1 ppm/K, or at least 10 ppm/K. That is, the linear expansion coefficient of each thermally insulating member 6 may be, for example, 0.1-200 ppm/K, 0.1-180 ppm/K, 0.1-150 ppm/K, 1-200 ppm/K, 1-180 ppm/K, 1-150 ppm/K, 10-200 ppm/K, 10-180 ppm/K, or 10-150 ppm/K. The linear expansion coefficient of each thermally insulating member 6 is measured, for example, by thermomechanical analysis (TMA).

The difference between the linear expansion coefficient of each thermally conductive portion 5 and the linear expansion coefficient of each thermally insulating member 6 may be, for example, at most 100 ppm/K, at most 80 ppm/K, at most 50 ppm/K, or at most 10 ppm/K. Due to the difference between the linear expansion coefficient of each thermally conductive portion 5 and the linear expansion coefficient of each thermally insulating member 6 being small, even if the thermoelectric conversion module 1 is attached to a heat source in a deformed state, said thermoelectric conversion module 1 can generate power while maintaining a stable temperature gradient without becoming peeled from the heat source.

The encapsulation layer 8 is arranged to cover the thermoelectric conversion region R1 and the two electrically conductive regions R2 on the first main surface 2a of the substrate 2. The encapsulation layer 8 may be bonded to the plurality of thermoelectric conversion groups 3 and the plurality of electrically conductive portions 4 in the thermoelectric conversion region R1 and the two electrically conductive regions R2. Additionally, the encapsulation layer 8 may be bonded to the first main surface 2a of the substrate 2 outside the thermoelectric conversion region R1 and the two electrically conductive regions R2. Although the shape of the encapsulation layer 8 in plan view is not particularly limited, the shape may be, for example, polygonal, circular, elliptical, etc.

The encapsulation layer 8 is a resin sheet member that exhibits heat resistance and flexibility, and for example, is substantially sheet-shaped. The resin constituting the substrate 2 is, for example, a polyalkylene-based resin (for example, a polypropylene-based resin, etc.), a (meth)acrylic-based resin, a (meth)acrylonitrile-based resin, a polyamide-based resin, a polycarbonate-based resin, a polyether-based resin, a polyester-based resin (for example, a polyethylene naphthalate-based resin, a PET-based resin, etc.), an epoxy-based resin, an organosiloxane-based resin, a polyimide-based resin, a polysulfone-based resin, etc.

The thickness (thickness in the thickness direction D1) of the encapsulation layer 8 may be, for example, at least 5 µm, at least 10 µm, at least 15 µm, or at least 20 µm. By setting the thickness of the encapsulation layer 8 to be thick, high output power can be maintained for a long time. The thickness of the encapsulation layer 8 (thickness in the thickness direction D1) may be, for example, at most 150 µm, at most 100 µm, at most 50 µm, or at most 40 µm. If the thickness of the encapsulation layer 8 is thin, excellent flexibility can be obtained. That is, the thickness (thickness in the thickness direction D1) of the encapsulation layer 8 may be, for example, 5-150 µm, 5-100 µm, 5-50 µm, 5-40 µm, 10-150 µm, 10-100 µm, 10-50 µm, 10-40 µm, 15-150 µm, 15-100 µm, 15-50 µm, 15-40 µm, 20-150 µm, 20-100 µm, 20-50 µm, or 20-40 µm.

The water vapor transmission rate in the thickness direction D1 of the encapsulation layer 8 may be, for example, at most 100 g/(m²·day), at most 80 g/(m²·day), at most 60 g/(m²·day), at most 40 g/(m²·day), at most 20 g/(m²·day), or at most 10 g/(m²·day). By setting the water vapor transmission rate in the thickness direction D1 of the encapsulation layer 8 to be low, high output power can be maintained for a long time. Additionally, the water vapor transmission rate in the thickness direction D1 of the encapsulation layer 8 may be, for example, at least 0.001 g/(m²·day), at least 0.01 g/(m²·day), at least 0.1 g/(m²·day), at least 0.5 g/(m²·day), at least 1 g/(m²·day), or at least 2 g/(m²·day). That is, the water vapor transmission rate in the thickness direction D1 of the encapsulation layer 8 may be, for example, 0.001-100 g/(m²·day), 0.001-80 g/(m²·day), 0.001-60 g/(m²·day), 0.001-40 g/(m²·day), 0.001-20 g/(m²·day), 0.001-10 g/(m²·day), 0.01-100 g/(m²·day), 0.01-80 g/(m²·day), 0.01-60 g/(m²·day), 0.01-40 g/(m²·day), 0.01-20 g/(m²·day), 0.01-10 g/(m²·day), 0.1-100 g/(m²·day), 0.1-80 g/(m²·day), 0.1-60 g/(m²·day), 0.1-40 g/(m²·day), 0.1-20 g/(m²·day), 0.1-10 g/(m²·day), 0.5-100 g/(m²·day), 0.5-80 g/(m²·day), 0.5-60 g/(m²·day), 0.5-40 g/(m²·day), 0.5-20 g/(m²·day), 0.5-10 g/(m²·day), 1-100 g/(m²·day), 1-80 g/(m²·day), 1-60 g/(m²·day), 1-40 g/(m²·day), 1-20 g/(m²·day), 1-10 g/(m²·day), 2-100 g/(m²·day), 2-80 g/(m²·day), 2-60 g/(m²·day), 2-40 g/(m²·day), 2-20 g/(m²·day), or 2-10 g/(m²·day). The water vapor transmission rate of the encapsulation layer 8 is measured by the cup method.

The emissivity of the encapsulation layer 8 may be, for example, at least 0.70, at least 0.80, or at least 0.90. By setting the emissivity of the encapsulation layer 8 to be high, heat can be efficiently discharged from the upper surface (the surface on the side opposite to the substrate 2) of the encapsulation layer 8, thereby improving the thermoelectric conversion performance. Additionally, the emissivity of the encapsulation layer 8 may be, for example, at most 0.99, at most 0.97, or at most 0.95. That is, the emissivity of the encapsulation layer 8 may be, for example, 0.70-0.99, 0.70-0.97, 0.70-0.95, 0.80-0.99, 0.80-0.97, 0.80-0.95, 0.90-0.99, 0.90-0.97, or 0.90-0.95. The emissivity of the encapsulation layer 8 is measured by an infrared thermography camera.

The thermal conductivity of the encapsulation layer 8 may be, for example, at least 0.01 W/mK, at least 0.05 W/mK, at least 0.1 W/mK, or at least 0.2 W/mK. If the thermal conductivity of the encapsulation layer 8 is high, heat can be efficiently discharged from the upper surface (the surface on the side opposite to the substrate 2) of the encapsulation layer 8, thereby improving the thermoelectric conversion performance. Additionally, the thermal conductivity of the encapsulation layer 8 may be, for example, at most 50 W/mK, at most 10 W/mK, at most 5 W/mK, at most 1 W/mK, or at most 0.5 W/mK. If the thermal conductivity of the encapsulation layer 8 is low, temperature differences occurring in the thermoelectric conversion layer tend to be easier to maintain. That is, the thermal conductivity of the encapsulation layer 8 may be, for example, 0.01-50 W/mK, 0.01-10 W/mK, 0.01-5 W/mK, 0.01-1 W/mK, 0.01-0.5 W/mK, 0.05-50 W/mK, 0.05-10 W/mK, 0.05-5 W/mK, 0.05-1 W/mK, 0.05-0.5 W/mK, 0.1-50 W/mK, 0.1-10 W/mK, 0.1-5 W/mK, 0.1-1 W/mK, 0.1-0.5 W/mK, 0.2-50 W/mK, 0.2-10 W/mK, 0.2-5 W/mK, 0.2-1 W/mK, or 0.2-0.5 W/mK. The thermal conductivity of the encapsulation layer 8 is measured by the laser flash method.

As illustrated in FIG. 4(a), the encapsulation layer 8 in the present embodiment may be disposed directly on the thermoelectric conversion portions 11 (on the p-type thermoelectric conversion elements 21 and the n-type thermoelectric conversion elements 22). Alternatively, as illustrated in FIG. 4(b), the encapsulation layer 8 in a modified example may be disposed on the thermoelectric conversion portions 11 with an adhesive layer 9 therebetween.

The adhesive layer 9 may be composed of an adhesive that can bond the encapsulation layer 8 with the thermoelectric conversion portions 11. The adhesive may be, for example, a pressure-sensitive adhesive. The adhesive may be, for example, a (meth)acrylic-based resin, an epoxy-based resin, a urethane-based resin, a urea-based resin, a phenolic-based resin, a melamine-based resin, a resorcinol-based resin, an isocyanate, a silicone, a chloroprene rubber, etc.

The thickness (thickness in the thickness direction D1) of the adhesive layer 9 may be, for example, at least 0.1 µm, at least 1 µm, or at least 10 µm. Additionally, the thickness (thickness in the thickness direction D1) of the adhesive layer 9 may be, for example, at most 500 µm, at most 200 µm, or at most 100 µm. That is, the thickness (thickness in the thickness direction D1) of the adhesive layer 9 may be, for example, 0.1-500 µm, 0.1-200 µm, 0.1-100 µm, 1-500 µm, 1-200 µm, 1-100 µm, 10-500 µm, 10-200 µm, or 10-100 µm.

The thermal conductivity of the adhesive layer 9 may be, for example, at least 0.01 W/mK, at least 0.05 W/mK, or at least 0.1 W/mK. If the thermal conductivity of the adhesive layer 9 is high, the effects due to discharging heat from the upper surface of the encapsulation layer 8 tend to be enhanced. Additionally, the thermal conductivity of the adhesive layer 9 may be, for example, at most 10 W/mK, at most 5 W/mK, or at most 1 W/mK. If the thermal conductivity of the adhesive layer 9 is low, temperature differences occurring in the thermoelectric conversion layer tend to be easier to maintain. That is, the thermal conductivity of the adhesive layer 9 may be, for example, 0.01-10 W/mK, 0.01-5 W/mK, 0.01-1 W/mK, 0.05-10 W/mK, 0.05-5 W/mK, 0.05-1 W/mK, 0.1-10 W/mK, 0.1-5 W/mK, or 0.1-1 W/mK.

The thermoelectric conversion module 1 may further comprise features other than the above. For example, the thermoelectric conversion module 1 may comprise wiring for electrically connecting another thermoelectric conversion module, wiring for extracting power to external circuitry, etc.

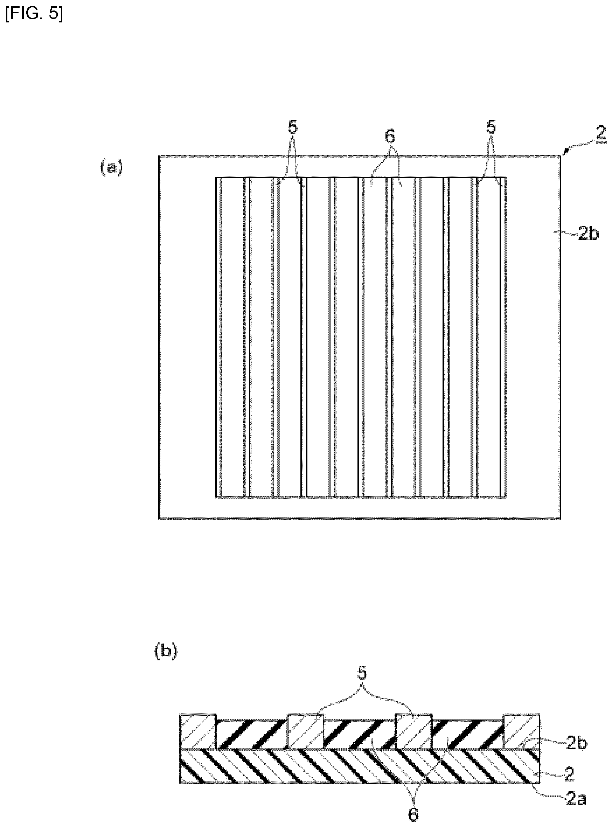

Next, an example of a manufacturing method for the thermoelectric conversion module 1 according to the present embodiment will be explained with reference to FIG. 5 to FIG. 7. FIG. 5(a) and (b), FIG. 6(a) and (b), and FIG. 7(a) and (b) are diagrams for explaining the manufacturing method for a thermoelectric conversion module according to the present embodiment.

First, as illustrated in FIG. 5(a) and (b), a plurality of thermally conductive portions 5 and a plurality of thermally insulating members 6 are formed on a second main surface 2b (on one of the main surfaces) of a substrate 2 that has been prepared in advance (first step). In the first step, for example, a high-thermal-conductivity material and a thermally insulating material are coated on the second main surface 2b by a known method such as an inkjet method, a dispensing method, a doctor blade method, or a screen printing method. The high-thermal-conductivity material and the thermally insulating material may be coated at the same time or may be coated at different timings. Next, the above-mentioned high-thermal-conductivity material and the above-mentioned thermally insulating material are cured by heating, thereby forming the plurality of thermally conductive portions 5 and thermally insulating members 6 on the second main surface 2b.

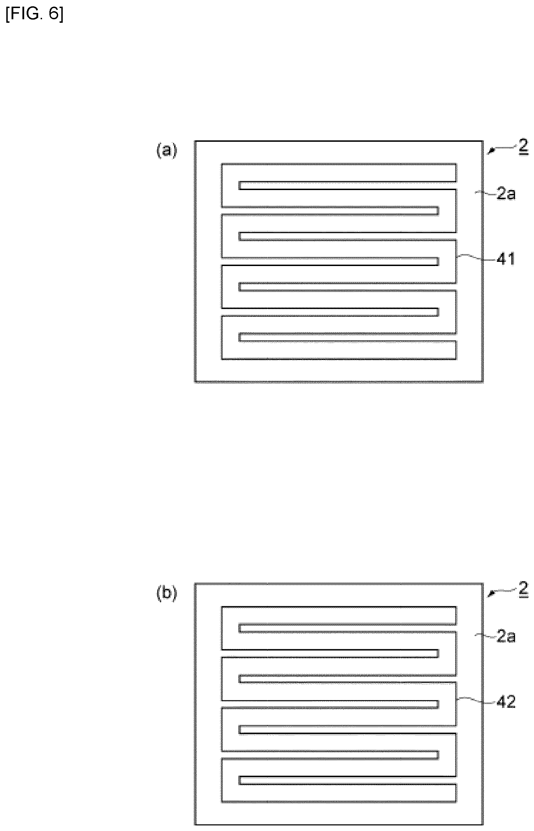

Next, as illustrated in FIG. 6(a), a first layer 41 is formed on the first main surface 2a (on the other main surface) (second step). In the second step, a dispersion liquid is first dripped onto the first main surface 2a by a known method such as, for example, an inkjet method, a dispensing method, a doctor blade method, a screen printing method, a casting method, a dip coating method, or a spray coating method. Next, the dispersion liquid is dried, thereby forming the first layer 41. For example, the substrate 2 is heated by placing the substrate 2 inside an air dryer set to at least 25 °C and at most 90 °C for at least 10 minutes and at most 21600 minutes. As a result thereof, the above-mentioned dispersion liquid is dried to form the first layer 41.

The dispersion liquid used in the second step is, for example, a liquid in which a p-type thermoelectric conversion material is dispersed. In the present embodiment, the dispersion liquid is a liquid in which carbon nanotubes and an electrically conductive resin are dispersed.

The carbon nanotube content in the dispersion liquid may be, for example, at least 20% by mass, at least 30% by mass, or at least 40% by mass with respect to the total amount of the electrically conductive resin and the carbon nanotubes. Additionally, the carbon nanotube content in the dispersion liquid may be, for example, at most 99% by mass, at most 95% by mass, or at most 90% by mass with respect to the total amount of the electrically conductive resin and the carbon nanotubes.

The total mass concentration of the carbon nanotubes and the electrically conductive resin in the dispersion liquid is, for example, at least 0.05% by mass, at least 0.06% by mass, at least 0.07% by mass, at least 0.10% by mass, at least 0.12% by mass, or at least 0.15% by mass. Additionally, the total mass concentration of the carbon nanotubes and the electrically conductive resin in the dispersion liquid is, for example, at most 10% by mass, at most 5% by mass, or at most 2% by mass. That is, the total mass concentration of the carbon nanotubes and the electrically conductive resin in the dispersion liquid may be, for example, 0.05-10% by mass, 0.05-5% by mass, 0.05-2% by mass, 0.06-10% by mass, 0.06-5% by mass, 0.06-2% by mass, 0.07-10% by mass, 0.07-5% by mass, 0.07-2% by mass, 0.10-10% by mass, 0.10-5% by mass, 0.10-2% by mass, 0.12-10% by mass, 0.12-5% by mass, 0.12-2% by mass, 0.15-10% by mass, 0.15-5% by mass, or 0.15-2% by mass.

The dispersion liquid used in the second step may be, for example, a liquid mixture formed by mixing a first liquid including the carbon nanotubes and a second liquid including the electrically conductive resin. The carbon nanotube content in the dispersion liquid with respect to the total amount of the electrically conductive resin and the carbon nanotubes is substantially equal to the percentage by mass of the carbon nanotubes with respect to the overall mass of the thermoelectric conversion portions 11. For this reason, in the present description, the carbon nanotube content in the dispersion liquid with respect to the total amount of the electrically conductive resin and the carbon nanotubes can be assumed to be the percentage by mass of the carbon nanotubes with respect to the overall mass of the thermoelectric conversion portions 11.

The first liquid includes, for example, carbon nanotubes and a first solvent. The first liquid may consist of carbon nanotubes dispersed in the first solvent. The carbon nanotube concentration in the first liquid is, for example, at least 0.01% by mass and at most 10% by mass. The first solvent need only be a solvent in which the carbon nanotubes can be dispersed, and may, for example, be a polar liquid or an aqueous solvent. Aqueous solvents are water or solvent mixtures of water and an organic solvent. The first solvent may be a protic solvent or may be an aprotic solvent. Specific examples of the first solvent include, for example, water, alcohols (methanol, ethanol, etc.), amides (N,N-dimethylformamide, N,N-dimethylacetamide, N-methylpyrrolidone, etc.), ketones (acetone, methylethylketone, etc.), glycols (ethylene glycol, diethylene glycol, etc.), dimethyl sulfoxide, acetonitrile, etc. Among these, one or more solvents selected from the group consisting of water, methanol, ethanol, N-methylpyrrolidone, and dimethyl sulfoxide are preferable, and water is more preferable. The first liquid may further include an additive such as a surfactant or an organic binder.

The second liquid includes, for example, an electrically conductive resin and a second solvent. The second solvent need only be a solvent in which the electrically conductive resin can be dispersed, and may, for example, be a polar liquid or an aqueous solvent. The second solvent may be a protic solvent or may be an aprotic solvent. Specific examples of the second solvent are the same as the specific examples of the first solvent. Among these, one or more solvents selected from the group consisting of water, methanol, and ethanol are preferable, and water is more preferable. In a first embodiment, the second liquid may be an aqueous dispersion of PEDOT/PSS. The second solvent may be of one type used alone or may be a mixture of two or more types. The second liquid may further include various types of additives.

Next, as illustrated in FIG. 6(b), the substrate 2 is immersed in an organic solvent, thereby forming a p-type thermoelectric conversion layer 42 (third step). In the present embodiment, after the second step, the first main surface 2a of the substrate 2 is immersed in dimethylsulfoxide (DMSO), which is the above-mentioned organic solvent (immersion treatment). For example, the first main surface 2a of the substrate 2 is immersed for at least one minute and at most 7200 minutes in dimethylsulfoxide that has been set to room temperature. After the immersion treatment, the substrate 2 may be heated inside an air dryer. For example, the substrate 2 is heated by placing the substrate 2 inside an air dryer set to at least 25 °C and at most 90 °C for at least 10 minutes and at most 21600 minutes. As a result of the above, a patterned p-type thermoelectric conversion layer 42 is formed. Parts of the p-type thermoelectric conversion layer 42 later form the n-type thermoelectric conversion elements 22. Other parts of the p-type thermoelectric conversion layer 42 later form the p-type thermoelectric conversion elements 21. Yet other parts of the p-type thermoelectric conversion layer 42 later form the electrically conductive portions 4.

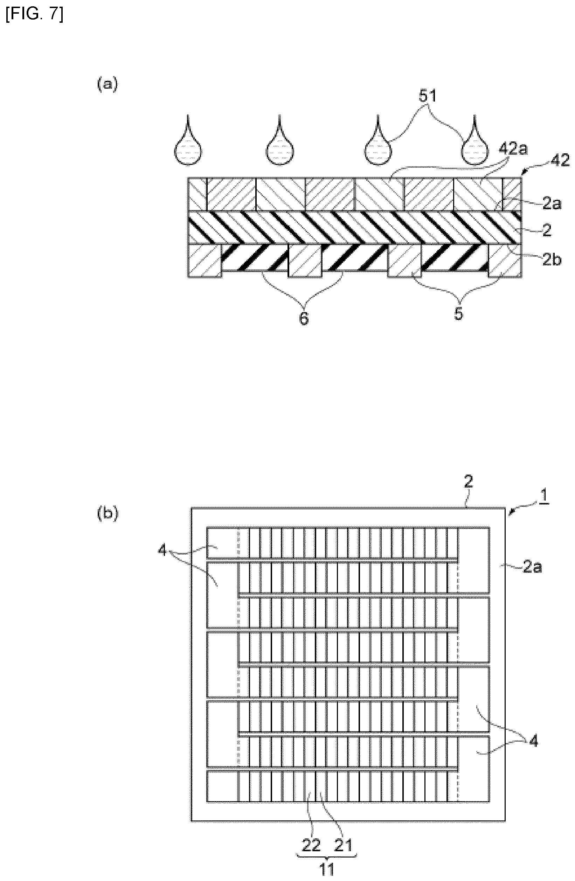

Next, as illustrated in FIG. 7(a), after the above-described third step, a solution (dopant solution 51) including a dopant is dripped onto parts 42a of the p-type thermoelectric conversion layer 42, thereby forming the p-type thermoelectric conversion elements 21, and the n-type thermoelectric conversion elements 22 at the parts 42a (fourth step). In the fourth step, the parts 42a of the p-type thermoelectric conversion layer 42 are impregnated with the dopant solution 51 by a known method such as, for example, an inkjet method or a dispensing method. In the present embodiment, the p-type thermoelectric conversion layer 42 is provided, in an alternating manner, with regions in which the dopant solution 51 has been dripped and regions in which the dopant solution 51 has not been dripped. Next, the above-mentioned parts 42a are changed to n-type thermoelectric conversion elements 22 by drying the dopant solution 51. For example, the substrate 2 is heated by placing the substrate on a hot plate set to at least 25 °C and at most 90 °C for at least 10 minutes and at most 21600 minutes. As a result thereof, the dopant solution 51 is dried. The solvent included in the dopant solution is, for example, water, acetonitrile, ethanol, ethylene glycol, dimethyl sulfoxide (DMSO), N-methylpyrrolidone, N,N-dimethylformamide, N,N-dimethylacetamide, etc. Additionally, the parts of the p-type thermoelectric conversion layer 42 on which the dopant solution 51 has not been dripped form the p-type thermoelectric conversion elements 21 or the electrically conductive portions 4, as illustrated in FIG. 7(b). As a result of the above, a plurality of thermoelectric conversion portions 11 are formed.

Next, an encapsulation layer 8 is provided so as to cover the plurality of thermoelectric conversion portions 11 and electrically conductive portions 4 that have been formed, thereby forming the thermoelectric conversion module 1 (fifth step). The encapsulation layer 8 may be bonded to the first main surface 2a of the substrate 2 by means of an adhesive (for example, a pressure-sensitive adhesive). Alternatively, the encapsulation layer 8 may be bonded to the first main surface 2a of the substrate 2 by fusion.

Next, the functions and effects achieved by the thermoelectric conversion module 1 formed by the manufacturing method according to the present embodiment described above will be explained.

The thermoelectric conversion module 1 according to the present embodiment has first thermally conductive portions 5a and a second thermally conductive portion 5b located on a second main surface 2b, the first thermally conductive portions 5a overlapping, in the thickness direction D1, with second ends 22b of n-type thermoelectric conversion elements 22 included in first thermoelectric conversion portions 11a, and the second thermally conductive portion 5b overlapping, in the thickness direction D1, with second ends 21b of p-type thermoelectric conversion elements 21 included in the first thermoelectric conversion portions 11a. Additionally, thermally insulating members 6 located between the first thermally conductive portions 5a and the second thermally conductive portion 5b are provided on the second main surface 2b. As a result thereof, the first thermally conductive portions 5a and the second thermally conductive portion 5b each do not overlap with the centers of the first thermoelectric conversion portions 11a while overlapping with both ends of the first thermoelectric conversion portions 11a. Thus, for example, by heating the first thermally conductive portions 5a and the second thermally conductive portion 5b, internal temperature differences can be favorably created in each of the p-type thermoelectric conversion elements 21 and the n-type thermoelectric conversion elements 22. Additionally, at least some of the thermally insulating members 6 overlap, in the thickness direction D1, with the centers of the thermoelectric conversion portions 11. As a result thereof, the temperatures at the centers of the thermoelectric conversion portions 11, which have relatively low temperatures, can be stabilized in the thermoelectric conversion portions 11 at the time of heating. For this reason, variations in the temperature differences inside the thermoelectric conversion portions 11 tend not to occur. Therefore, by employing the thermoelectric conversion module 1 according to the present embodiment, the output power per unit area can be increased and stabilized output power can be realized without depending on the temperature of the heat source.

The thermoelectric conversion module 1 according to the present embodiment is provided with an encapsulation layer 8 so as to cover the thermoelectric conversion portions 11 on the first main surface 1a. Furthermore, the encapsulation layer 8 has, in the thickness direction D1, a thickness of at least 5 µm and at most 150 µm and a water vapor transmission rate of at most 100 g/(m²·day). According to discoveries by the present inventors, with the thermoelectric conversion module 1 according to the present embodiment, although there were conventionally cases in which the output power decreased due to n-type thermoelectric conversion elements changing to p-type conductivity when used for a long time, by providing the above-mentioned encapsulation layer 8, the change to p-type conductivity is suppressed and high output power can be maintained for a long time. In the present embodiment, the conversion to p-type conductivity is significantly suppressed by the thickness of the encapsulation layer 8 in the thickness direction D1 being at least 5 µm and the water vapor transmission rate being at most 100 g/(m²·day). Additionally, in the present embodiment, by setting the thickness of the encapsulation layer 8 in the thickness direction D1 to be at most 150 µm (in some cases, further setting the water vapor transmission rate to be at least 0.1 g/(m²·day)), even if the thermoelectric conversion module 1 is attached to a heat source in a deformed state, the encapsulation layer 8 does not easily peel from the thermoelectric conversion portions 11 and power can be stably generated.

Additionally, in the present embodiment, the encapsulation layer 8 has an emissivity of at least 0.70 and at most 0.99, and a thermal conductivity of at least 0.01 W/mK and at most 50 W/mK. In the present embodiment, due to the encapsulation layer 8 having an emissivity of at least 0.70 and a thermal conductivity of at least 0.01 W/mK, the heat retained in the thermoelectric conversion portions 11 can be efficiently discharged through the encapsulation layer 8, and a stably high output power can be realized. Additionally, in the present embodiment, due to the thermal conductivity of the encapsulation layer 8 being at most 50 W/mK, the transfer of heat from the high-temperature portions to the low-temperature portions of the thermoelectric conversion portions 11 through the encapsulation layer 8 can be sufficiently suppressed and power can be generated by maintaining a stable temperature gradient.

In the present embodiment, the difference in the linear expansion coefficient of the first thermally conductive portions 5a and the second thermally conductive portion 5b with respect to that of the thermally insulating members 6 may be at most 100 ppm/K. In this case, even if the thermoelectric conversion module 1 is attached to a heat source in a deformed state, the thermoelectric conversion module 1 will not easily peel from the heat source and power can be more stably generated.

In the present embodiment, the thickness T1 of the p-type thermoelectric conversion elements 21 (and the thickness of the n-type thermoelectric conversion elements 22) may be at least 3 µm and at most 30 µm. Due to the thickness T1 being within the above-mentioned range, the number of elements pure unit area can be increased and the internal resistance of the elements can be sufficiently suppressed.

In the present embodiment, the linear expansion coefficient of each of the first thermally conductive portions 5a and the second thermally conductive portion 5b may be at least 100 ppm/K and at most 200 ppm/K, and the linear expansion coefficient of the thermally insulating members 6 may be at most 200 ppm/K. In this case, even if the thermoelectric conversion module 1 is attached to a heat source in a deformed state, the thermoelectric conversion module 1 can generate power while maintaining a more stable temperature gradient without becoming peeled from the heat source.

In the present embodiment, the width L2 of each thermally conductive portion 5 in the first direction D2 may be at least 0.5 mm and at most 1.5 mm. In this case, better heat transfer performance due to each thermally conductive portion 5 can be obtained and the internal temperature differences in the thermoelectric conversion portions 11 can be made larger.

In the present embodiment, the thermal conductivity of each of the first thermally conductive portions 5a and the thermally conductive portion 5b may be at least 2 W/mK and at most 5 W/mK, and the thermal conductivity of the thermally insulating members 6 may be at least 0.01 W/mK and at most 0.05 W/mK. In this case, internal temperature differences in the thermoelectric conversion portions 11 can be more favorably created.

In the present embodiment, the thickness T1 of the p-type thermoelectric conversion elements 21 may be at least 5 µm and at most 25 µm. The spacing S may be at least 3 mm and less than 12 mm. In these cases, further improvement of the output power per unit area of the thermoelectric conversion module 1 can be realized.

In the present embodiment, the substrate 2, the thermoelectric conversion portions 11, the thermally conductive portions 5, and the thermally insulating members 6 may exhibit flexibility. In this case, the thermoelectric conversion module 1 can be easily provided, for example, along the surface of a tubular pipe. That is, restrictions on the locations of attachment of the thermoelectric conversion module 1 can be loosened.

In the present embodiment, a dopant solution 51 can be dripped onto parts 42a of a p-type thermoelectric conversion layer 42, thereby forming n-type thermoelectric conversion elements 22 from said parts 42a. In this case, the contact resistance between the p-type thermoelectric conversion elements 21 and the n-type thermoelectric conversion elements 22 can be favorably reduced. Additionally, in this case, since the output power tends to decrease due to the conversion to p-type conductivity mentioned above, the effects of the above-mentioned encapsulation layer 8 are more significantly achieved. Additionally, the dopant solution 51 may be dripped after the thermally conductive portions 5 have been formed. As a result thereof, the material contained in the dopant solution 51 will not tend to deteriorate due to heating, etc.

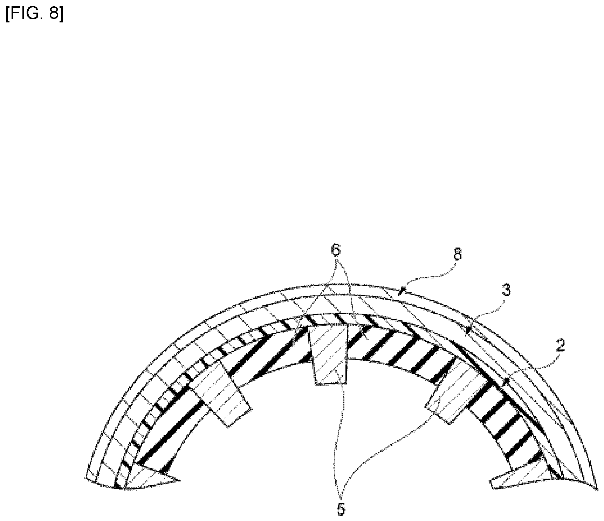

In the present embodiment, the length T3, in the thickness direction D1, of each thermally insulating member 6 is smaller than the length T2 of each thermally conductive portion 5. For example, the length T3 is at most 80%, or at most 70% of the length T2. In this case, as illustrated in FIG. 8, the thermally insulating members 6 tend not to hinder the deformation of the substrate 2. As a result thereof, for example, compressive stress, etc. does not tend to be excessively concentrated at the boundaries, etc. between the thermally conductive portions 5 and the thermally insulating members 6, and therefore, the thermally insulating members 6 tend not to peel from the substrate 2 when the thermoelectric conversion module 1 is deformed.

The thermoelectric conversion module and the manufacturing method thereof according to the present disclosure are not limited to the above-described embodiments and the above-described modified examples, and various other modifications are possible.

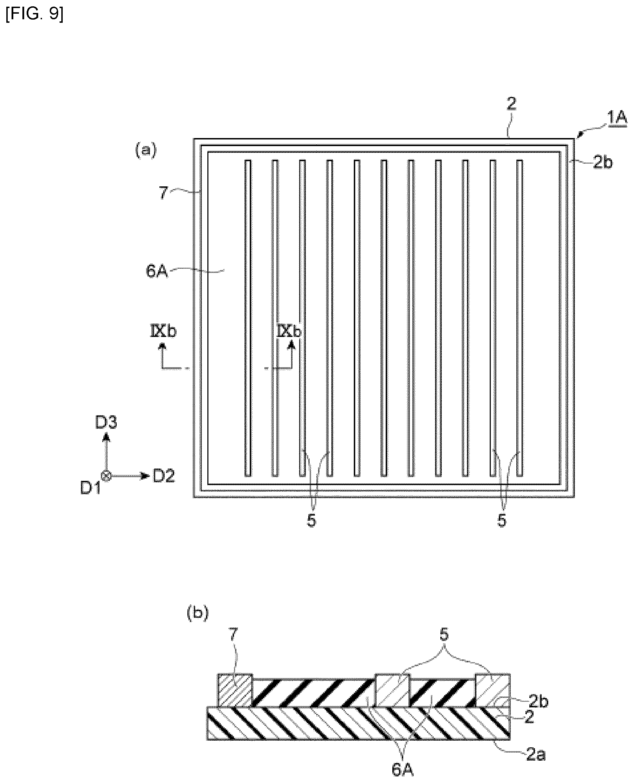

FIG. 9(a) is a schematic bottom view of a thermoelectric conversion module according to a modified example. FIG. 9(b) is a schematic section view along the line IXb-IXb in FIG. 9(a). In FIG. 9(b), the features provided on the first main surface 2a are omitted. The thermoelectric conversion module 1A illustrated in FIG. 9(a) and (b) differs from the thermoelectric conversion module 1 of the above-described embodiment in that a heat dissipation member 7 located on the second main surface 2b is further provided. Additionally, the shape of the thermally insulating member 6A provided in the thermoelectric conversion module 1A differs from the shape of the thermally insulating members 6 in the above-described embodiment. The heat dissipation member 7 is a member for dissipating heat that has accumulated in the thermoelectric conversion module 1A, and is in the shape of a frame surrounding each thermally conductive portion 5 and the thermally insulating member 6A in plan view. In the present modified example, the heat dissipation member 7 is in the shape of a rectangular frame. However, there is no limitation thereto. The thermally insulating member 6A is provided so as to fill the area surrounded by the heat dissipation member 7. For this reason, the thermally insulating member 6A contacts not only each thermally conductive portion 5, but also the heat dissipation member 7, and each thermally conductive portion 5 is surrounded by the thermally insulating member 6A in plan view.

The thermal conductivity of the heat dissipation member 7 is at least higher than the thermal conductivity of the substrate 2, and may be, for example, at least 1 W/mK, at least 1.5 W/mK, or at least 2 W/mK. Additionally, the thermal conductivity of the heat dissipation member 7 may be, for example, at most 400 W/mK, at most 200 W/mK, or at most 100 W/mK. That is, the thermal conductivity of the heat dissipation member 7 may be, for example, 1-400 W/mK, 1-200 W/mK, 1-100 W/mK, 1.5-400 W/mK, 1.5-200 W/mK, 1.5-100 W/mK, 2-400 W/mK, 2-200 W/mK, or 2-100 W/mK. The thermal conductivity of the heat dissipation member 7 is measured by a steady-state method or by a non-steady-state method.

The difference between the linear expansion coefficient, in the in-plane direction, of the heat dissipation member 7 and the linear expansion coefficient of the thermally insulating members 6 may be, for example, at most 100 ppm/K, at most 80 ppm/K, or at most 50 ppm/K. As a result thereof, even if the thermoelectric conversion module 1A is attached to a heat source in a deformed state, the thermoelectric conversion module 1A can generate power while maintaining a stable temperature gradient without becoming peeled from the heat source.

Even in the modified example explained above, functions and effects similar to those of the above-described embodiment can be obtained. Additionally, by providing the heat dissipation member 7, heat does not tend to accumulate in the thermoelectric conversion module 1A, and therefore, temperature differences in the thermoelectric conversion portions 11 can be more easily maintained.

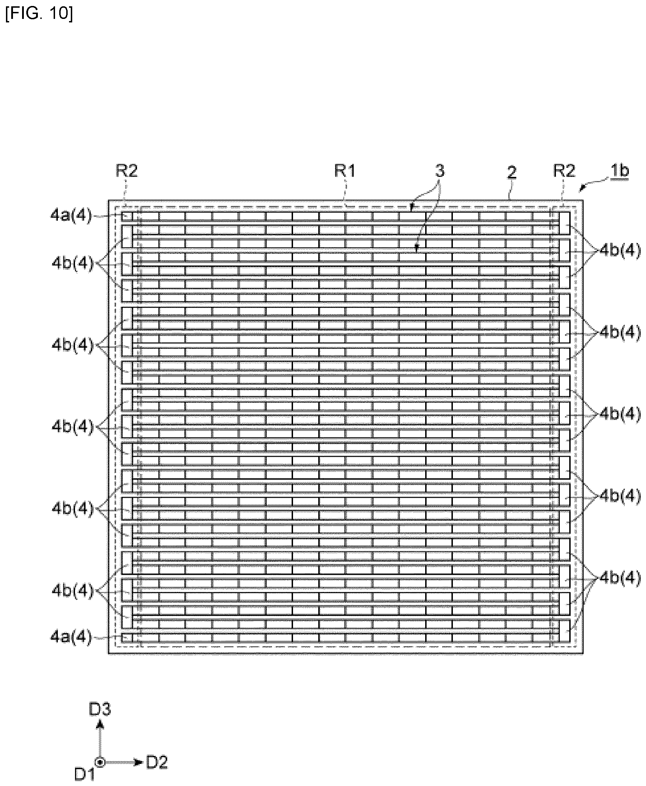

FIG. 10 is a schematic plan view for explaining a thermoelectric conversion module according to a modified example. In FIG. 10, the encapsulation layer 8 is omitted. That is, FIG. 10 can be considered to be a diagram illustrating the state in which the encapsulation layer 8 has been removed from the thermoelectric conversion module 1b or a diagram illustrating the state before the encapsulation layer 8 is provided during the manufacture of the thermoelectric conversion module 1b.

The thermoelectric conversion module 1b explained in FIG. 10 differs from the thermoelectric conversion module 1 of the above-described embodiment in that the length, in the second direction D3, of each of the plurality of thermoelectric conversion groups 3 is shorter that the length in the first direction. Additionally, in the thermoelectric conversion module 1b, the number of thermoelectric conversion groups 3 differs from that in the thermoelectric conversion module 1 of the above-described embodiment. In the thermoelectric conversion module 1b, more thermoelectric conversion groups 3 are arrayed in the second direction D3 by making the lengths of the thermoelectric conversion groups 3 shorter in the second direction D3.

Functions and effects similar to those in the above-described embodiment can also be obtained in the modified examples explained above.

In the above-described embodiment and the above-described modified examples, the thermally insulating members are formed by drying a thermally insulating material that has been coated onto the substrate. However, there is no limitation thereto. For example, pre-formed thermally insulating members may be fixed onto the substrate.

### EXAMPLES

Aspects of the present disclosure will be explained in further detail by means of the examples below. However, the aspects of the present disclosure are not limited to these examples.

### (Example 1)

A thermoelectric conversion module was fabricated as indicated below.

### <Thermally insulating member>

A thermal insulation sheet ("Finesulite^{®}, normal type", manufactured by Sumitomo Riko Co., Ltd., thickness 0.63 mm, silica aerogel, thermal conductivity 0.02 W/mK, linear expansion coefficient 136 ppm/K) was cut to a width of 10 mm and a length of 96 mm to form a thermally insulating member.

### <Dispersion liquid>

Vacuum suction was used to concentrate 80 g of a carbon nanotube dispersion liquid (concentration 0.2% by mass, G/D ratio 41, aqueous dispersion liquid, single-layered carbon nanotubes, diameter 0.9-1.7 nm, thermal conductivity 30 W/mK) until the carbon nanotube concentration became 0.4% by mass. Next, 5.7 g of an aqueous PEDOT/PSS dispersion liquid ("Clevious PH1000", manufactured by Heraeus K.K., solid concentration 1.2% by mass) and the concentrated carbon nanotube dispersion liquid were stirred well (stirring time 30 minutes) with a three-one motor ("Model PM203" manufactured by As One Corp.). As a result thereof, a dispersion liquid in which the carbon nanotube content was 50% by mass with respect to the total amount of the PEDOT/PSS and carbon nanotubes was prepared. The viscosity of the dispersion liquid with a shear rate of 0.01 s⁻¹ was 1320000 mPa·s. The viscosity of the dispersion liquid was measured by using a rheometer ("MCR302" (product name) manufactured by Anton Paar). The measurement conditions were such that the temperature was 25 °C, the plates were *ϕ*25 mm parallel plates, and the gap was 1 mm.

### <Dopant solution>

A dopant solution was formed by dissolving 0.32 g of potassium ferrocyanide trihydrate and 0.94 g of benzo-18-crown-6-ether into 15 mL of ultrapure water. The concentrations of potassium ions and benzo-18-crown-6-ether in the dopant solution were each set to be 0.2 M. The molar ratio (C₂/C₁) was 1.

### <Substrate>

As the substrate, a 100-mm square polyethylene naphthalate film (manufactured by Toyobo Co., Ltd., film thickness 25 µm, water vapor transmission rate 6.0 g/(m²·day), emissivity 0.93, thermal conductivity 0.33 W/mK, flexural modulus 2.3 GPa) was prepared. The above-mentioned polyethylene naphthalate film was washed with acetone and used as the substrate.

### <Encapsulation layer>

As the encapsulation layer, a 100-mm square polyethylene naphthalate film (manufactured by Toyobo Co., Ltd., film thickness 25 µm, water vapor transmission rate 6.0 g/(m²·day), emissivity 0.93, thermal conductivity 0.33 W/mK, flexural modulus 2.3 GPa) was prepared. The above-mentioned polyethylene naphthalate film was washed with acetone and adhesive tape (No. 585 manufactured by Nitto Denko Corp., the adhesive layer was an acrylic adhesive) was adhered to one main surface thereof.

### <Manufacture of thermoelectric conversion module>

The first main surface of the above-mentioned substrate was coated with the above-mentioned dispersion liquid using a jet dispenser, "AeroJet", and a tabletop robot, "SHOTMASTER 400ΩX", manufactured by Musashi Engineering, Inc. Next, the laminate coated with the dispersion liquid was stored for three hours in an air dryer set to 60 °C. As a result thereof, a composite film having a thickness of 21 µm was formed on the first main surface of the substrate. The composite film is provided with both a thermoelectric conversion region and an electrically conductive portion on the first main surface of the substrate.

The direction of extension of the thermoelectric conversion region is orthogonal to the directions of extension of the above-mentioned thermally conductive portion and the above-mentioned thermally insulating member. The thickness of the composite film was measured by using a high-precision Digimatic micrometer (MDH-25MB, manufactured by Mitutoyo Corp.). Specifically, the thickness of the portion provided with the composite film and the thickness of the portion not provided with the composite film (the portion with only the substrate) were each measured, and the difference therebetween was assumed to be the thickness of the composite film.

Next, the first main surface of the above-mentioned substrate was immersed for 30 minutes in DMSO (manufactured by Fujifilm Wako Pure Chemical Corp.) at room temperature. Then, the substrate extracted from the DMSO was disposed for 120 minutes on a hot plate set to 60 °C. As a result thereof, a p-type thermoelectric conversion layer was formed on the first main surface of the substrate. In Example 1, the thickness of the p-type thermoelectric conversion layer was 4.7 µm. Additionally, the thermal conductivity of the p-type thermoelectric conversion layer in the in-plane direction was 32 W/mK.

Next, an inkjet printer, "Material Printer DMP2850", manufactured by Fujifilm Corp., was used to drip the dopant solution on some portions of the p-type thermoelectric conversion layer that are to function as thermoelectric conversion elements. In Example 1, first, the dopant solution was dripped over a range with a width of 2 mm in a first direction and a length of 5.5 mm in a second direction. Then, leaving a spacing with a length of 5.5 mm in the first direction, the dopant solution was similarly dripped over a range with a width of 2 mm and a length of 5.5 mm. By repeating this dripping operation, regions in which the dopant solution was dripped and regions in which it was not dripped were arrayed in an alternating manner.

Next, the substrate was dried for 30 minutes, then, the substrate was stored for 60 minutes in an air dryer set to 100 °C.

As a result of the above, 48 each of p-type thermoelectric conversion elements and n-type thermoelectric conversion elements were formed on the substrate. That is, a total of 96 thermoelectric conversion elements were formed on the substrate. Thus, a total of 48 thermoelectric conversion portions each having one p-type thermoelectric conversion element and one n-type thermoelectric conversion element were formed. In this case, the thickness of the n-type thermoelectric conversion elements was substantially the same as the thickness of the p-type thermoelectric conversion elements. The ends of each thermoelectric conversion portion overlapped with a thermally conductive portion, and at least the center of each thermoelectric conversion portion did not overlap with a thermally conductive portion. The iron atom content in the n-type thermoelectric conversion elements was at least 0.01% by mass and at most 10% by mass.

Next, the side of the above-mentioned encapsulation layer with the adhesive tape was pressed against the first main surface of the substrate on which the p-type thermoelectric conversion elements and the n-type thermoelectric conversion elements were formed. The substrate was placed in a chamber of a manual hydraulic vacuum heated press (Model IMC-11FD, manufactured by Imoto Machinery Co., Ltd.), the plate temperature was set to 80 °C, and vacuum suction was applied for one minute. The substrate was pressed for at least 10 minutes with a pressing force of 1 kN. Due to the above, a laminate having thermoelectric conversion elements sandwiched between a base material and an encapsulation layer was obtained.

Next, one surface of the above-mentioned thermally insulating member was coated with spray glue (regular series S/N 55, manufactured by 3M Japan Ltd.), and was bonded to the second main surface of the substrate while leaving gaps of 1.0 mm. Next, a dispenser, "AD3000C", and a tabletop robot, "EzROBO-5GX", manufactured by Iwashita Engineering, Inc., were used to coat the above-mentioned gaps with a high-thermal-conductivity material (G-789, manufactured by Shin-etsu Chemical Co., Ltd.). At this time, the spacing in the first direction between nozzle location from which the high-thermal-conductivity material was discharged was set to be 11 mm, and the coating was performed while moving said nozzles in the second direction, orthogonal to the first direction. As a result thereof, the second main surface was coated with multiple strips of the high-thermal-conductivity material. After the coating, the substrate was disposed for 60 minutes on a hot plate set to 120 °C. As a result thereof, multiple thermally conductive portions (linear expansion coefficient 140 ppm/K, thermal conductivity 3.0 W/mK) were formed. The length T2 of the thermally conductive portions 5 was 1 mm, the width L2 of the thermally conductive portions was 1 mm, and the spacing S between thermally conductive portions in the first direction was 10 mm. Additionally, the thermally insulating members (linear expansion coefficient 136 ppm/K, thermal conductivity 0.02 W/mK) were arranged and fixed so as to fill the above-mentioned 10 mm spacing.

As a result of the above, the thermoelectric conversion module of Example 1 was produced.

### (Example 2)

A thermoelectric conversion module was produced in a manner similar to Example 1, aside from having used, in the production of the substrate and the encapsulation layer, a PET film (manufactured by Toray Industries, Inc., film thickness 25 µm, water vapor transmission rate 25 g/(m²·day), emissivity 0.92, thermal conductivity 0.31 W/mK, flexural modulus 2.5 GPa) instead of the polyethylene naphthalate film.

### (Example 3)

A thermoelectric conversion module was produced in a manner similar to Example 1, aside from having used, in the production of the substrate and the encapsulation layer, a polypropylene film (manufactured by Toray Industries, Inc., film thickness 25 µm, water vapor transmission rate 8.0 g/(m²·day), emissivity 0.90, thermal conductivity 0.13 W/mK, flexural modulus 2.3 GPa) instead of the polyethylene naphthalate film.

### (Example 4)

A thermoelectric conversion module was produced in a manner similar to Example 1, aside from having used, in the production of the substrate and the encapsulation layer, a PET film (manufactured by Toray Industries, Inc., film thickness 12 µm, water vapor transmission rate 50 g/(m²·day), emissivity 0.92, thermal conductivity 0.31 W/mK, flexural modulus 2.5 GPa) instead of the polyethylene naphthalate film.

### (Example 5)

A thermoelectric conversion module was produced in a manner similar to Example 1, aside from having used, in the production of the substrate and the encapsulation layer, a polyethylene naphthalate film (manufactured by Toyobo Co., Ltd., film thickness 100 µm, water vapor transmission rate 1.6 g/(m²·day), emissivity 0.93, thermal conductivity 0.33 W/mK, flexural modulus 2.3 GPa) instead of the polyethylene naphthalate film.

### (Example 6)

A thermoelectric conversion module was produced in a manner similar to Example 1, aside from having used, in the production of the substrate and the encapsulation layer, a polyimide film (manufactured by Toray Industries, Inc., film thickness 25 µm, water vapor transmission rate 76 g/(m²·day), emissivity 0.95, thermal conductivity 0.29 W/mK, flexural modulus 3.5 GPa) instead of the polyethylene naphthalate film.

### (Comparative Example 1)

A thermoelectric conversion module was produced in a manner similar to Example 1, aside from having used, in the production of the encapsulation layer, a polyimide film (manufactured by Toray Industries, Inc., film thickness 25 µm, water vapor transmission rate 76 g/(m²·day), emissivity 0.95, thermal conductivity 0.29 W/mK, flexural modulus 3.5 GPa) instead of the polyethylene naphthalate film, and having not provided an encapsulation layer.

### (Comparative Example 2)

A thermoelectric conversion module was produced in a manner similar to Example 1, aside from having used, in the production of the substrate and the encapsulation layer, a polyimide film (manufactured by Toray Industries, Inc., film thickness 12.5 µm, water vapor transmission rate 161 g/(m²·day), emissivity 0.95, thermal conductivity 0.29 W/mK, flexural modulus 3.5 GPa) instead of the polyethylene naphthalate film.

### (Comparative Example 3)

A thermoelectric conversion module was produced in a manner similar to Example 1, aside from having used, in the production of the substrate, a polyimide film (manufactured by Toray Industries, Inc., film thickness 25 µm, water vapor transmission rate 76 g/(m²·day), emissivity 0.95, thermal conductivity 0.29 W/mK, flexural modulus 3.5 GPa) instead of the polyethylene naphthalate film, and having used, in the production of the encapsulation layer, an aluminum foil (manufactured by Mitsubishi Aluminum Corp., film thickness 25 µm, water vapor transmission rate 0.001 g/(m²·day), emissivity 0.04, thermal conductivity 204 W/mK) instead of the polyethylene naphthalate film.

### (Comparative Example 4)

A thermoelectric conversion module was produced in a manner similar to Example 1, aside from having used, in the production of the substrate and the encapsulation layer, a polyethylene naphthalate film (manufactured by Toyobo Co., Ltd., film thickness 188 µm, water vapor transmission rate 0.9 g/(m²·day), emissivity 0.93, thermal conductivity 0.33 W/mK, flexural modulus 2.3 GPa) instead of the polyethylene naphthalate film.

### (Evaluation of thermoelectric conversion module)

The thermoelectric conversion modules of Examples 1-6 and Comparative Examples 1-4 were evaluated by the methods indicated below. The results are shown in Table 1 and Table 2.

### <Flexibility evaluation>

The fabricated thermoelectric conversion modules were curved. Those with excellent flexibility that could be easily curved were graded A, those with sufficient flexibility that could be curved were graded B, and those with inferior flexibility that were difficult to curve were graded C.

### <Output power evaluation>

The thermally conductive portions of a thermoelectric conversion module were brought into contact with a hot plate at 100 °C to create a temperature difference in each thermoelectric conversion element, and the maximum output power of the thermoelectric conversion module was evaluated by using a source meter ("Keithley 2612B", manufactured by Tektronix, Inc.). The maximum output power of each thermoelectric conversion module was evaluated relative to the maximum output power of the thermoelectric conversion module of Comparative Example 1, which was defined to be 100.

### <Long-term reliability evaluation>

A thermoelectric conversion module was placed at rest in an environment with a temperature of 85 °C and a humidity of 85%, then extracted after a prescribed time period elapsed, and the maximum output power of the thermoelectric conversion module was evaluated by using a source meter ("Keithley 2612B", manufactured by Tektronix, Inc.). The time periods during which the output power was below 20% of the initial value were calculated, and said time periods were provided as the reliability evaluation results.

**[Table 1]**

| | Example 1 | Example 2 | Example 3 | Example 4 | Example 5 | Example 6 |
|---|---|---|---|---|---|---|
| Flexibility | A | A | A | A | B | A |
| Maximum output power | 120 | 115 | 110 | 115 | 105 | 110 |
| Long-term reliability (hr) | 2100 | 500 | 2050 | 280 | >5000 | 150 |

**[Table 2]**

| | Comparative Example 1 | Comparative Example 2 | Comparative Example 3 | Comparative Example 4 |
|---|---|---|---|---|
| Flexibility | A | A | A | C |
| Maximum output power | 100 | 110 | 8 | 120 |
| Long-term reliability (hr) | 50 | 70 | >5000 | >5000 |

As indicated in Table 1 and Table 2, thermoelectric conversion modules having high output power, high long-term reliability and good flexibility were obtained with Examples 1-6. In contrast therewith, the conversion to p-type conductivity of the n-type thermoelectric conversion elements progressed too quickly, causing the long-term reliability to become poor in Comparative Example 1, which lacked an encapsulation layer, and in Comparative Example 2, in which the water vapor transmission rate of the encapsulation layer was higher than 100 g/(m²·day). Additionally, the temperature gradient in the thermoelectric conversion portions was inadequate, causing the maximum output power to be poor in Comparative Example 3, in which the encapsulation layer had a thermal conductivity lower than 0.01 W/mK and an emissivity lower than 0.70. Additionally, the flexibility was poor in Comparative Example 4, in which the thickness of the encapsulation layer was greater than 150 µm.

### REFERENCE SIGNS LIST

- 1, 1A, 1b: Thermoelectric conversion module
- 2: Substrate
- 2a: First main surface
- 2b: Second main surface
- 3: Thermoelectric conversion group
- 3a: First thermoelectric conversion group
- 3b: Second thermoelectric conversion group
- 4: Electrically conductive portion
- 5: Thermally conductive portion
- 5a: First thermally conductive portion
- 5b: Second thermally conductive portion
- 6, 6A: Thermally insulating member
- 7: Heat dissipation member
- 8: Encapsulation layer
- 9: Adhesive layer
- 11: Thermoelectric conversion portion
- 11a: First thermoelectric conversion portion
- 11b: Second thermoelectric conversion portion
- 21: P-type thermoelectric conversion element
- 21a: First end
- 21b: Second end
- 22: N-type thermoelectric conversion element
- 22a: First end
- 22b: Second end
- D1: Thickness direction
- D2: First direction
- D3: Second direction
- L1: Length
- L2: Width
- S: Spacing
- R1: Thermoelectric conversion region
- R2: Electrically conductive region
- T1: Thickness
- T2, T3: Length

## Claims

1. A thermoelectric conversion module comprising:
a substrate having a first main surface, and a second main surface located on a side opposite to the first main surface;
a thermoelectric conversion portion located on the first main surface;
an encapsulation layer located on the thermoelectric conversion portion;
a first thermally conductive portion and a second thermally conductive portion that are located on the second main surface and that are adjacent to each other in a first direction orthogonal to a thickness direction of the substrate; and
a thermally insulating member that is located on the second main surface, at least between the first thermally conductive portion and the second thermally conductive portion;
the thermoelectric conversion portion has a p-type thermoelectric conversion element and an n-type thermoelectric conversion element that are arranged side by side in the first direction;
a first end of the p-type thermoelectric conversion element in the first direction contacts a first end of the n-type thermoelectric conversion element in the first direction, and overlaps with the thermally insulating member in the thickness direction;
the first thermally conductive portion overlaps, in the thickness direction, with a second end of the p-type thermoelectric conversion element in the first direction;
the second thermally conductive portion overlaps, in the thickness direction, with a second end of the n-type thermoelectric conversion element in the first direction;
the encapsulation layer has, in the thickness direction, a thickness of at least 5 µm and at most 150 µm, and a water vapor transmission rate of at most 100 g/(m²·day); and
an emissivity of the encapsulation layer is at least 0.70 and at most 0.99, and a thermal conductivity of the encapsulation layer is at least 0.01 W/mK and at most 50 W/mK.

2. The thermoelectric conversion module according to claim 1, wherein the encapsulation layer has a water vapor transmission rate of at least 0.1 g/(m²·day) and at most 100 g/(m²·day).

3. The thermoelectric conversion module according to claim 1 or 2, wherein a difference in linear expansion coefficient between the first thermally conductive portion and the thermally insulating member and a difference in linear expansion coefficient between the second thermally conductive portion and the thermally insulating member are each at most 100 ppm/K.

4. The thermoelectric conversion module according to claim 1 or 2, wherein the p-type thermoelectric conversion element and the n-type thermoelectric conversion element each have a thickness of at least 3 µm and at most 30 µm.

5. The thermoelectric conversion module according to claim 1 or 2, wherein:
the first thermally conductive portion and the second thermally conductive portion each have a linear expansion coefficient of at least 100 ppm/K and at most 200 ppm/K; and
the linear expansion coefficient of the thermally insulating member is at most 200 ppm/K.

6. The thermoelectric conversion module according to claim 1 or 2, wherein the first thermally conductive portion and the second thermally conductive portion each have a width, in the first direction, of at least 0.5 mm and at most 1.5 mm.

7. The thermoelectric conversion module according to claim 1 or 2, wherein:
the first thermally conductive portion and the second thermally conductive portion each have a thermal conductivity of at least 2 W/mK and at most 5 W/mK; and
the thermal conductivity of the thermally insulating member is at least 0.02 W/mK and at most 0.05 W/mK.

8. The thermoelectric conversion module according to claim 1 or 2, wherein:
a heat dissipation member located on the second main surface is further provided; and
viewed from the thickness direction, the heat dissipation member surrounds the first thermally conductive portion, the second thermally conductive portion, and the thermally insulating member.

9. The thermoelectric conversion module according to claim 1 or 2, wherein:
the p-type thermoelectric conversion element and the n-type thermoelectric conversion element each have a thickness of at least 5 µm and at most 25 µm; and
a spacing between the first thermally conductive portion and the second thermally conductive portion in the first direction is at least 3 mm and less than 12 mm.

10. The thermoelectric conversion module according to claim 1 or 2, further comprising:
a first thermoelectric conversion group that is located on the first main surface and that has the thermoelectric conversion portion; and
a second thermoelectric conversion group that is located on the first main surface and that is adjacent to the first thermoelectric conversion group in a second direction that is orthogonal to the thickness direction and to the first direction;
wherein
the second thermoelectric conversion group has a second thermoelectric conversion portion adjacent to the first thermoelectric conversion portion in the second direction;
the second thermoelectric conversion portion has a second p-type thermoelectric conversion element and a second n-type thermoelectric conversion element that are arranged side by side in the first direction;
a first end of the second p-type thermoelectric conversion element in the first direction contacts a first end of the second n-type thermoelectric conversion element in the first direction, and overlaps with the thermally insulating member in the thickness direction;
the first thermally conductive portion and the second thermally conductive portion each extend in the second direction;
the first thermally conductive portion overlaps, in the thickness direction, with a second end, in the first direction, of the second p-type thermoelectric conversion element included in the second thermoelectric conversion portion; and
the second thermally conductive portion overlaps, in the thickness direction, with a second end, in the first direction, of the second n-type thermoelectric conversion element included in the second thermoelectric conversion portion.

11. The thermoelectric conversion module according to claim 10, further comprising:
a first electrically conductive portion that is located on the first main surface and that is connected to one end of the first thermoelectric conversion group in the first direction; and
a second electrically conductive portion that is located on the first main surface and that is connected to the other end of the first thermoelectric conversion group in the first direction and to one end of the second thermoelectric conversion group in the second direction;
wherein the first electrically conductive portion and the second electrically conductive portion are each of the same conductivity type.

12. The thermoelectric conversion module according to claim 1 or 2, wherein the substrate, the thermoelectric conversion portion, the first thermally conductive portion, the second thermally conductive portion, and the thermally insulating member each exhibit flexibility.

13. A manufacturing method for a thermoelectric conversion module, the manufacturing method comprising:
a first step of forming a first thermally conductive portion, a second thermally conductive portion, and a thermally insulating member on one main surface of a substrate;
a second step of forming a first layer including a p-type thermoelectric conversion material on the other main surface of the substrate;
after the second step, a third step of immersing the other main surface of the substrate in an organic solvent, thereby forming a p-type thermoelectric conversion layer;
after the third step, a fourth step of dripping a dopant solution onto a portion of the p-type thermoelectric conversion layer, thereby forming a p-type thermoelectric conversion element, and an n-type thermoelectric conversion element at said portion; and
after the fourth step, a fifth step of disposing an encapsulation layer on the other main surface of the substrate so as to cover the p-type thermoelectric conversion element and the n-type thermoelectric conversion element;
wherein
the first thermally conductive portion and the second thermally conductive portion are adjacent to each other in a first direction orthogonal to a thickness direction of the substrate;
a first end of the p-type thermoelectric conversion element in the first direction contacts a first end of the n-type thermoelectric conversion element in the first direction, and overlaps with the thermally insulating member in the thickness direction;
the first thermally conductive portion overlaps, in the thickness direction, with a second end of the p-type thermoelectric conversion element in the first direction;
the second thermally conductive portion overlaps, in the thickness direction, with a second end of the n-type thermoelectric conversion element in the first direction;
the encapsulation layer has, in the thickness direction, a thickness of at least 5 µm and at most 150 µm, and a water vapor transmission rate of at most 100 g/(m²·day); and
an emissivity of the encapsulation layer is at least 0.70 and at most 0.99, and a thermal conductivity of the encapsulation layer is at least 0.01 W/mK and at most 50 W/mK.

14. The manufacturing method according to claim 13, wherein the encapsulation layer has a water vapor transmission rate of at least 0.1 g/(m²·day) and at most 100 g/(m²·day).
